# EUROPÄISCHE PATENTSCHRIFT

(11) **EP 2 938 618 B1**
(45) Veröffentlichungstag und Bekanntmachung des Hinweises auf die Patenterteilung: **15.11.2017**
(21) Anmeldenummer: 13821678.3
(22) Anmeldetag: 16.12.2013
(51) Int. Cl.: C07F 1/08, H01L 51/50

(54) **ZWEIKERNIGE METALL(I)-KOMPLEXE FÜR OPTOELEKTRONISCHE ANWENDUNGEN**
BINUCLEAR METAL(I) COMPLEXES FOR USE IN OPTOELECTRONICS
COMPLEXES MÉTAUX(I) BINUCLÉAIRES POUR APPLICATIONS OPTOÉLECTRONIQES

(30) Priorität: 27.12.2012 EP 12199403; 08.05.2013 EP 13167032
(43) Veröffentlichungstag der Anmeldung: 04.11.2015
(73) Patentinhaber: cynora GmbH, 76646 Bruchsal (DE)
(72) Erfinder: VOLZ, Daniel, 76137 Karlsruhe (DE); JACOB, Andreas, 76137 Karlsruhe (DE); BAUMANN, Thomas, 76133 Karlsruhe (DE); GRAB, Tobias, 76133 Karlsruhe (DE)
(74) Vertreter: Hoppe, Georg Johannes
(86) Internationale Anmeldenummer: PCT/EP2013/076682
(87) Internationale Veröffentlichungsnummer: WO 2014/102079

(56) Entgegenhaltungen:
- WO-A1-2012/098263
- DE-A1-102009 030 475
- JP-A- 2006 286 749
- MANOJ TRIVEDI ET AL: "Synthesis, characterization, crystal structures and photophysical properties of copper(I) complexes containing 1,1-bis(diphenylphosphino)ferrocene (B-dppf) in doubly-bridged mode", INORGANICA CHIMICA ACTA, ELSEVIER BV, NL, Bd. 376, Nr. 1, 15. Juli 2011 (2011-07-15) , Seiten 549-556, XP028292942, ISSN: 0020-1693, DOI: 10.1016/J.ICA.2011.07.024 [gefunden am 2011-07-23]
- MOHAMED A. EL-SAYED ET AL.: "Stoichiomnetry and kinetics of oxidation of dimeric bis(mu-halo)bis((diamine)copper(I)) complexes L2Cu2X by dioxygen in aprotic solvents", INORG. CHEM., Bd. 24, 1985, Seiten 3387-3390, XP002698413,
- MOHAMED A. EL-SAYED ET AL.: "Products and kinetics of the oxidation of neutral dimeric iodo(N,N,N',N'-tetraalkyl diamine)copper(I) complexes [LCuI]2 by dioxygen in nitrobenzene", INORG. CHEM., Bd. 29, 1990, Seiten 4730-4735, XP002698414,
- HABAUE ET AL: "Oxidative cross-coupling leading to 3-amido substituted 1,1'-bi-2-naphthol derivatives", TETRAHEDRON LETTERS, ELSEVIER, AMSTERDAM, NL, Bd. 48, Nr. 41, 14. September 2007 (2007-09-14), Seiten 7301-7304, XP022244716, ISSN: 0040-4039, DOI: 10.1016/J.TETLET.2007.08.036
- PRIYADARSHINI S ET AL: "Bis(-iodo)bis(()-sparteine)dicopper(I) catalyzed Sonogashira-type reaction under palladium and phosphine-free conditions", TETRAHEDRON LETTERS, ELSEVIER, AMSTERDAM, NL, Bd. 52, Nr. 14, 26. Januar 2011 (2011-01-26), Seiten 1615-1618, XP028185569, ISSN: 0040-4039, DOI: 10.1016/J.TETLET.2011.01.119 [gefunden am 2011-02-03]
- HUILING CUI ET AL.: "synthesis and coordination chmeistry of N.N-diallylbispidine", ORGANOMETALLICS, Bd. 30, 2011, Seiten 6241-6252, XP002698415,
- TAKAKI IMAIZUMI ET AL: "Group 11 Metal Amide-Catalyzed Asymmetric Cycloaddition Reactions of Azomethine Imines with Terminal Alkynes", JOURNAL OF THE AMERICAN CHEMICAL SOCIETY, Bd. 134, Nr. 49, 12. Dezember 2012 (2012-12-12), Seiten 20049-20052, XP055065999, ISSN: 0002-7863, DOI: 10.1021/ja311150n
- SANDRA Y. DE BOER ET AL.: "CuI click catalysis with cooperative noninnocent pyridylphosphine ligands", INORG. CHIM. ACTA, Bd. 380, 17. Oktober 2011 (2011-10-17), Seiten 336-342, XP002721969,
- GAKU HATTORI ET AL: "Copper-Catalyzed Enantioselective Propargylic Amination of Propargylic Esters with Amines: Copper-Allenylidene Complexes as Key Intermediates", JOURNAL OF THE AMERICAN CHEMICAL SOCIETY, Bd. 132, Nr. 30, 4. August 2010 (2010-08-04), Seiten 10592-10608, XP055065993, ISSN: 0002-7863, DOI: 10.1021/ja1047494
- BRUCE ET AL: "Crystal and molecular structures of {Cu(mu-C?CPh)(triphos)}2 [triphos=(PPh2CH2)3CMe]", INORGANICA CHIMICA ACTA, ELSEVIER BV, NL, Bd. 360, Nr. 2, 14. Januar 2007 (2007-01-14), Seiten 681-685, XP005830689, ISSN: 0020-1693, DOI: 10.1016/J.ICA.2006.05.038
- JOSEFINA DIEZ ET AL.: "Novel copper(I) complexes containing 1,2'-bis(diphenylphosphino)ferrocene (dppf) as a chelate and bridging ligand", ORGANOMETALLICS, Bd. 18, 1999, Seiten 662-669, XP002721970,
- NEO S P ET AL: "Nitrato displacement in [Ag2(NO3)2(mu-dppf)2]. Molecular structure of a homoleptic dppf complex, [Ag2(mu-dppf)(dppf)2] (PF6)2 (dppf = 1,1'-bis(diphenylphosphino)ferrocene)", JOURNAL OF ORGANOMETALLIC CHEMISTRY, ELSEVIER-SEQUOIA S.A. LAUSANNE, CH, Bd. 464, Nr. 1, 11. Januar 1994 (1994-01-11), Seiten 113-119, XP026648119, ISSN: 0022-328X, DOI: 10.1016/0022-328X(94)87018-7 [gefunden am 1994-01-11]
- DATABASE CA [Online] CHEMICAL ABSTRACTS SERVICE, COLUMBUS, OHIO, US; XP002721971, gefunden im STN Database accession no. 119:49571

## Beschreibung

Die Erfindung betrifft zweikernige Metall(I)komplexe der allgemeinen Formel A, insbesondere zur Verwendung in optoelektronischen Bauelementen.

### Einleitung

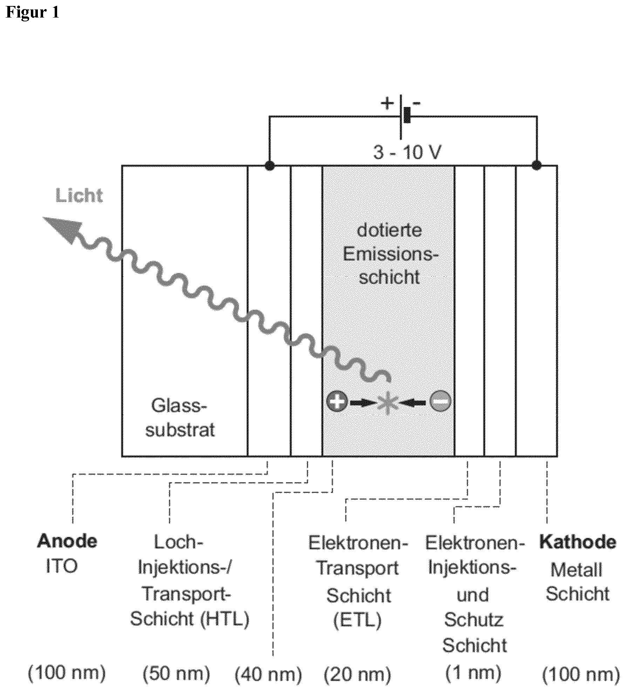

Zurzeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLEDs,** den **O**rganic **L**ight **E**mitting **D**iodes, die in Figur 1 schematisch und vereinfacht dargestellt ist.

Derartige Bauteile bestehen vorwiegend aus organischen Schichten, wie in Figur 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.^{[i-vi]} Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.^{[i-v]} Für Triplett-Emitter wurden bereits viele Schutzrechte beantragt bzw. erteilt.^{[vii-xix]}

Kupferkomplexe der Form Cu₂X₂L₄, Cu₂X₂L'₂ und Cu₂X₂L₂L' (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC (*cluster centered*)*-* oder XLCT (*halogen-to-ligand-charge-transfer*)-Zustand oder einer Kombination dieser stammen. Weitere Einzelheiten zu ähnlichen Cu(I)-Systemen können der Literatur entnommen werden.^{[xx]} Bei dem verwandten [Cu₂X₂(PPh₃)₂nap]-Komplex (nap = 1,8-Naphthyridin, X = Br, I) wird ein Übergang zwischen dem Molekülorbital der {Cu₂X₂}-Einheit (Cu d und Halogen p-Orbitale) und den π*-Orbitalen der nap-Gruppe diskutiert.^{[xxi]}

Die als JP 2006286749 A veröffentlichte japanische Patentanmeldung betrifft ein lichtemittierendes Element, welches ein lichtemittierendes Material in Form eines einkernigen Kupferkomplexes enthält.

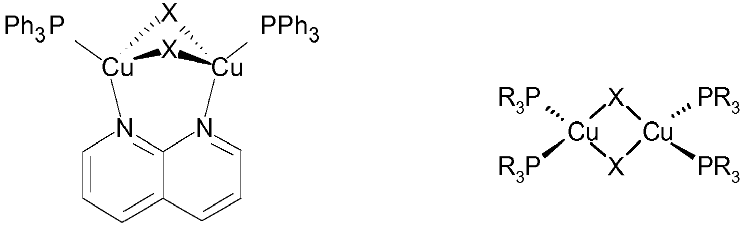

Beispiel einer Struktur der Komplexe der Form Beispiele der Komplexe der Form Cu₂X₂L₄ (L = Cu₂X₂L₂L' (L = PPh₃, L' = 1,8-Naphthyridin, X PR₃, X = Cl, Br, oder I) = Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund lag der vorliegenden Erfindung die Aufgabe zu Grunde, zumindest einige der oben genannten Nachteile zu überwinden.

### Beschreibung der Erfindung

Das der Erfindung zu Grunde liegende Problem wird durch die Bereitstellung von zweikernigen Metall(I)komplexen der Form M₂X₂(E∩D)₂ gelöst, die eine Struktur gemäß Formel A aufweisen oder von einer Struktur nach Formel A sind:

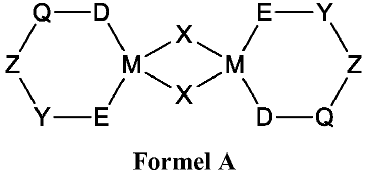

In Formel A (nachfolgend auch als M₂X₂(E∩D)₂ bezeichnet) steht E∩D unabhängig voneinander für einen zweizähnigen chelatisierenden Liganden, der über ein Donoratom D* und ein Donoratom E*, die unabhängig voneinander ausgewählt sind aus der Gruppe bestehend aus N, wobei N kein Imin-Stickstoffatom oder Teil eines N-heteroaromatischen Rings ist, P, C*, O, S, As und Sb an den M₂X₂-Kern bindet, wobei die beiden Donoratome D* und E* verschieden voneinander sind und durch die drei Einheiten Q, Y, Z verbunden sind und somit einen zweizähnigen Liganden ergeben, und wobei in einer bevorzugten Ausführungsform die folgenden Kombinationen aus D* und E* zulässig sind:

| | | | | | | | | | | | | | | |
|---|---|---|---|---|---|---|---|---|---|---|---|---|---|---|
| D* = | N | N | N | N | N | N | P | P | P | P | P | C* | C* | C* |
| E* = | P | C* | O | s | As | Sb | N | C* | O | As | Sb | N | P | O |

| | | | | | | | | | | | | | | |
|---|---|---|---|---|---|---|---|---|---|---|---|---|---|---|
| D* = | C* | C* | C* | O | O | O | O | O | O | S | S | S | S | S |
| E* = | s | As | Sb | N | P | C* | S | As | Sb | N | C* | O | As | Sb |

| | | | | | | | | | | | | | | |
|---|---|---|---|---|---|---|---|---|---|---|---|---|---|---|
| D* = | As | As | As | As | As | As | Sb | Sb | Sb | Sb | Sb | Sb | | |
| E* = | N | P | C* | O | S | Sb | N | P | C* | O | s | As | | |

X steht unabhängig voneinander für Cl, Br, I, CN, OCN, SCN, Alkinyl und/oder N₃, M steht unabhängig voneinander für Cu und Ag. C* steht für ein divalentes Carben-Kohlenstoffatom. Bei ∩ handelt es sich um eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Beide Liganden E∩D können auch weiter substituiert und/oder anneliert und/oder auch miteinander verbunden sein, so dass sich ein vierzähniger Ligand ergibt.

Q ist sowohl mit D als auch mit Z verbunden, wobei eine erste Bindung zwischen einem Atom Q* des Substituenten Q und einem Atom D* des Substituenten D ausgebildet wird, und wobei eine zweite Bindung zwischen einem Atom Q* des Substituenten Q und einem Atom Z* des Substituenten Z ausgebildet wird. Analoges gilt für Y, eine erste Bindung wird zwischen einem Atom Y* des Substituenten Y und einem Atom E* des Substituenten E ausgebildet, und eine zweite Bindung zwischen einem Atom Y* des Substituenten Y und einem Atom Z* des Substituenten Z ausgebildet. Analoges gilt für Z, eine erste Bindung wird zwischen einem Atom Z* des Substituenten Z und einem Atom Q* des Substituenten Q* ausgebildet, und eine zweite Bindung zwischen einem Atom Z* des Substituenten Z und einem Atom Y* des Substituenten Y ausgebildet. Q*, Y* und Z* sind unabhängig voneinander ausgewählt aus der Gruppe bestehend aus C, N, O, S und P.

Folgende Kombinationen direkt benachbarter Atome D*, E*, Q*, Y* und Z* sind in einer Ausführungsform der Erfindung nicht zulässig: P-N, N-As, N-Sb, O-O, P-P, P-As, P-Sb.

Jedes R ist unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Aus der Unterschiedlichkeit von D und E resultiert ein unsymmetrischer Ligand und daraus folglich ein Komplex mit sehr niedriger Symmetrie (wenig Symmetrieoperationen möglich), der im Gegensatz zu hoch-symmetrischen Komplexen (viele Symmetrieoperationen möglich) eine sehr geringe Neigung hat zu kristallisieren. Da Materialien für optoelektronische Vorrichtungen wie OLEDs amorphe Schichten ausbilden müssen, da polykristalline Bereiche gebildete Excitonen strahlungslos löschen, sind Verbindungen mit einer hohen Kristallinität ungeeignet, da hierbei Entmischungseffekte und Konzentrationsquenching auftreten können. In nicht stabilen Filmen, die während des Betriebs der OLED kristallisieren, können die Korngrenzen der Kristalle als Fallenzustände agieren. Daher ist ein wichtiges Kriterium für die Entwicklung organischer Funktionsmaterialien optoelektronischer Vorrichtungen wie OLEDs die Beständigkeit des amorphen Zustandes. Thermische Beanspruchung während des Betriebes einer OLED kann zu einem Übergang des metastabilen amorphen Zustandes zum thermodynamisch stabilen Kristall führen. Dies hat weitreichende Konsequenzen für die Lebensdauer des Bauteiles. Die Korngrenzen einzelner Kristallite stellen Fehlstellen dar, an denen der Transport von Ladungsträgern zum Erliegen kommt. Ebenso führt die mit der Kristallisation einhergehende Umstrukturierung der Schichten zu einem verminderten Kontakt der Schichten untereinander und mit den Elektroden. Dies führt beim Betrieb mit der Zeit zum Auftreten von dunklen Stellen ("dark spots") und letztlich zur Zerstörung der OLED.

Somit lag der vorliegenden Erfindung die Aufgabe zu Grunde, oben genannte Nachteile bei Verwendung symmetrischer und dadurch leichter kristallisierbarer Komplexe zu überwinden und Emittermaterialien bereitzustellen, die aufgrund ihrer deutlich geringeren Symmetrie diese nachteiligen Eigenschaften nicht aufweisen.

Der Ligand E∩D kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Spezielle Ausführungsformen der erfindungsgemäßen zweikernigen Metall(I)komplexe der Formel A werden durch die Verbindung der Formeln I bis IX dargestellt und im Folgenden erläutert. 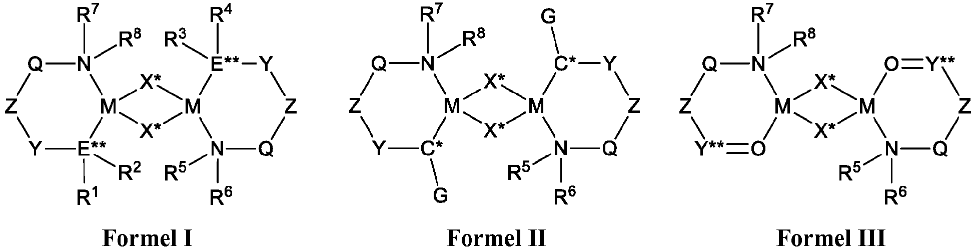 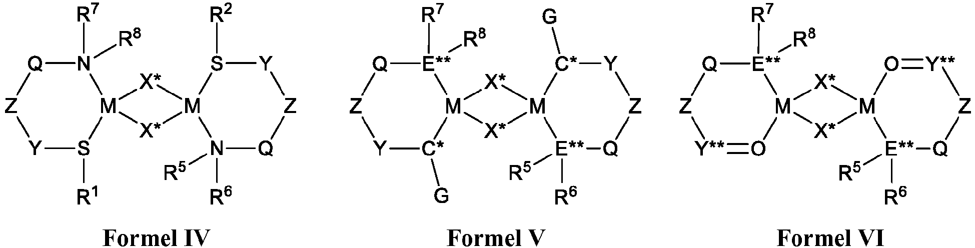 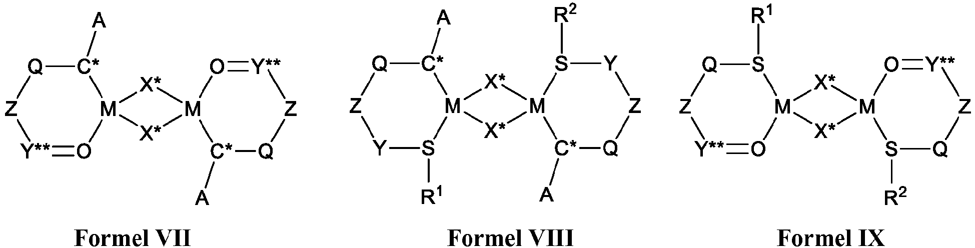 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Y** = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. Die Reste R¹-R⁸ können optional auch zu annelierten Ringsystemen führen.

Die Einheit QC*A ist in einer Ausführungsform ausgewählt aus der Gruppe bestehend aus: 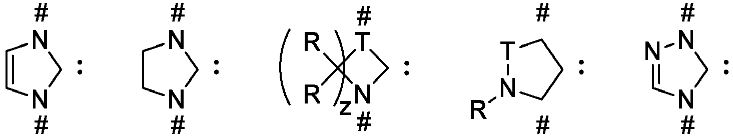 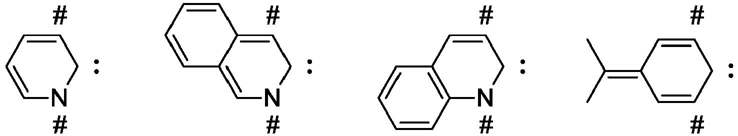 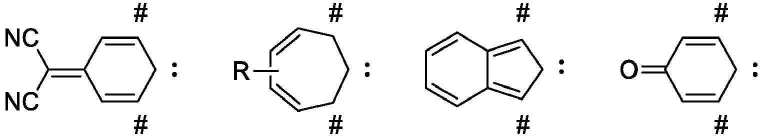 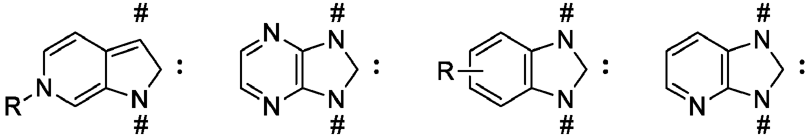 wobei die zwei Punkte ":" für ein divalentes Carben-Kohlenstoffatom stehen, das an das Metall koordiniert, und die Verknüpfung von Q mit Z an einer der mit # gekennzeichneten Stellen stattfindet und somit A das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R ist unabhängig voneinander ebenfalls ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
und z für die ganzen Zahlen 1, 2, 3 oder 4 steht.

Der zweizähnige Ligand E∩D kann optional substituiert sein, insbesondere mit funktionellen Gruppen, die den Ladungsträgertransport verbessern und/oder Gruppen, die die Löslichkeit des Metall(I)komplexes in den gängigen organischen Lösungsmitteln zur OLED-Bauteilherstellung erhöhen. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Durch die Koordination der zweizähnigen Liganden E∩D wird die Stabilität und Rigidität des Metall(I)komplexes stark erhöht. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Metall(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Metall(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden E∩D in den Formeln I bis IX um folgende Liganden: 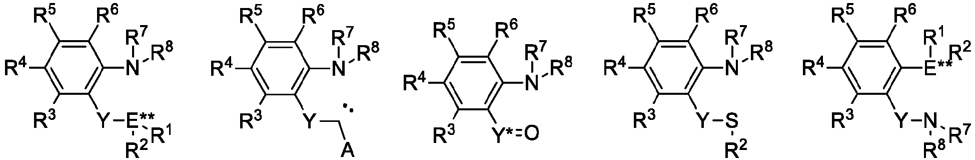 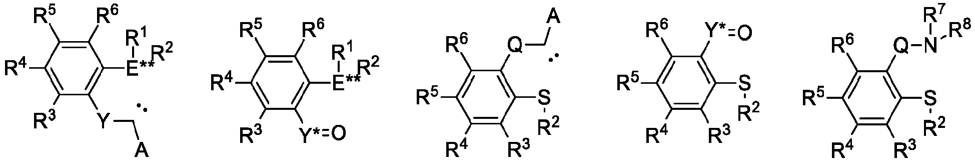 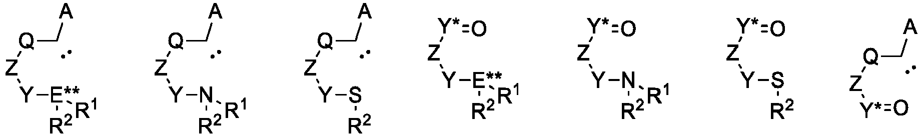 mit
E** = ausgewählt aus der Gruppe bestehend aus P, As und Sb,
: = ein Carben-Kohlenstoffatom,
A = unabhängig voneinander Substituenten ausgewählt aus der Gruppe bestehend aus NRR', OR, SR und PRR' sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
A und Q und G und Y können optional jeweils miteinander verbunden sein, sodass sich ein Imidazolidin- oder ein Imidazolderivat ausbildet und/oder mit der Einheit Z und/oder den Resten R³-R⁸ auch zu annelierten Ringsystemen führen,
Y* = unabhängig voneinander ausgewählt aus der Gruppe bestehend aus CR, N, PRR', SR, S(O)R; R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind. R³-R⁸ können optional auch zu annelierten Ringsystemen führen.

Der zweizähnige Ligand E∩D kann an geeigneten Stellen mit mindestens einer Funktions-Gruppe FG substituiert sein. So können sich direkte C_{FG}-C_{E∩D} Bindungen bilden, wobei C_{E∩D} ein C-Atom des E∩D Liganden darstellt und C_{FG} ein C-Atom der Funktions-Crruppe. Ist das anbindende Atom ein Stickstoffatom, so ergeben sich N_{FG}-C_{E∩D} Bindungen, wobei N_{FG} für das Stickstoffatom steht. Andererseits kann die Funktions-Gruppe über eine Brücke an den E∩D Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{E∩D}, C_{FG}-S-C_{E∩D}, C_{FG}-C(O)-O-C_{E∩D}, C_{FG}-C(O)-NH-C_{E∩D}, C_{FG}-CH₂-C_{E∩D}, C_{FG}-SiR'₂-C_{E∩D}C_{N}∗_{∩E}, C_{FG}-CH=CH-C_{E∩D}, C_{FG}-C≡C-C_{E∩D}, N_{FG}-CH₂-C_{E∩D}.

Die Verfahren zur Verknüpfung der Funktionsgruppe an den E∩D Ligand, entweder direkt oder über eine Brücke, sind dem Fachmann bekannt (Suzuki-, Still-, Heck-, Sonogashira-, Kumada-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R auch ein elektronenleitender, lochleitender oder die Löslichkeit erhöhender Substituent sein.

Die Erfindung betrifft auch ein Verfahren zur Herstellung eines erfindungsgemäßen Metall(I)komplexes. Dieses erfindungsgemäße Verfahren weist den Schritt des Durchführens einer Reaktion des zweizähnigen Liganden E∩D mit M(I)X auf,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl und N₃,
E∩D = ein zweizähniger Ligand mit

E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;

D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind

"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch), Heteroalkyl-, Aryl-, Heteroaryl- und weitere allgemein bekannte Donor- und Akzeptor-Gruppen, wie beispielsweise Amine, Carboxylate und deren Ester, und CF₃-Gruppen, die optional weiter substituiert und/oder anneliert sind. R ist unabhängig voneinander ausgewählt aus der Gruppe bestehend aus Wasserstoff, Halogen und Substituenten, die direkt oder über Sauerstoff-(-OR), Stickstoff- (-NR₂), Silizium- (-SiR₃) oder Schwefelatome (-SR) gebunden sind sowie Alkyl-(auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.

Der optional am Liganden E∩D vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen E∩D-Liganden mit M(I)X (M = Ag, Cu; X = Cl, Br, I), bevorzugt in Dichlormethan (DCM), bevorzugt bei Raumtemperatur, entsteht der zweikernige 2:2-Komplex M₂X₂(E∩D)₂, in dem jedes Metallatom durch je einen Liganden zweifach koordiniert sowie die beiden Halogenid-Anionen überbrückt wird (Gl. 1).

Die Struktur der Formel A ist verwandt mit bekannten Komplexen der Form Cu₂X₂L₂L' bzw. Cu₂X₂L₄. Im Gegensatz zu Cu₂X₂L₄ mit vier einzähnigen Liganden L (L = PR₃ oder Pyridin, X = Cl, Br, oder I) ist die Stabilität des hier beschriebenen Komplexes durch Verwendung von zwei zweizähnigen Liganden der Form E∩D viel größer (erkennbar beispielsweise durch Absorptions- und Emissionsmessungen des Komplexes in Lösung und als Filme) und zusätzlich die Rigidität des Komplexes stark erhöht. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

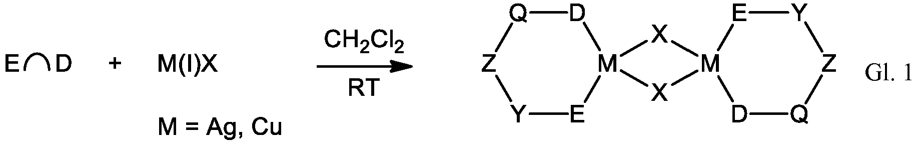

Hierbei handelt es sich um die oben aufgeführte allgemeine Formel A. Der zweizähnige E∩D-Ligand kann mindestens einen Rest R umfassen, der jeweils unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Die Substituenten können auch zu anellierten Ringsystemen führen.

### Substituenten zur Einführung unterschiedlicher Funktionalitäten

Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports können entweder einfach oder mehrfach am E∩D-Liganden gebunden sein. Es können identische oder unterschiedliche Funktions-Gruppen verwendet werden. Die Funktions-Gruppen können symmetrisch oder unsymmetrisch vorhanden sein.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumada-, Ullmann-, Buchwald-Hartwig-Kupplung sowie deren Varianten zu Einsatz.

Dabei geht man von einem mit Halogenid (Cl, Br, I), insbesondere Br, substituierten E∩D-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und E∩D-Ligand. Bei Anwesenheit von - OH Gruppen kommen hier z. B. Veresterungen und Etherbildung in Frage, bei -NH₂ Gruppen Imin- und Amidbildung, bei -COOH Gruppen Esterbildung. Entsprechend muss das Substitutionsmuster des E∩D-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

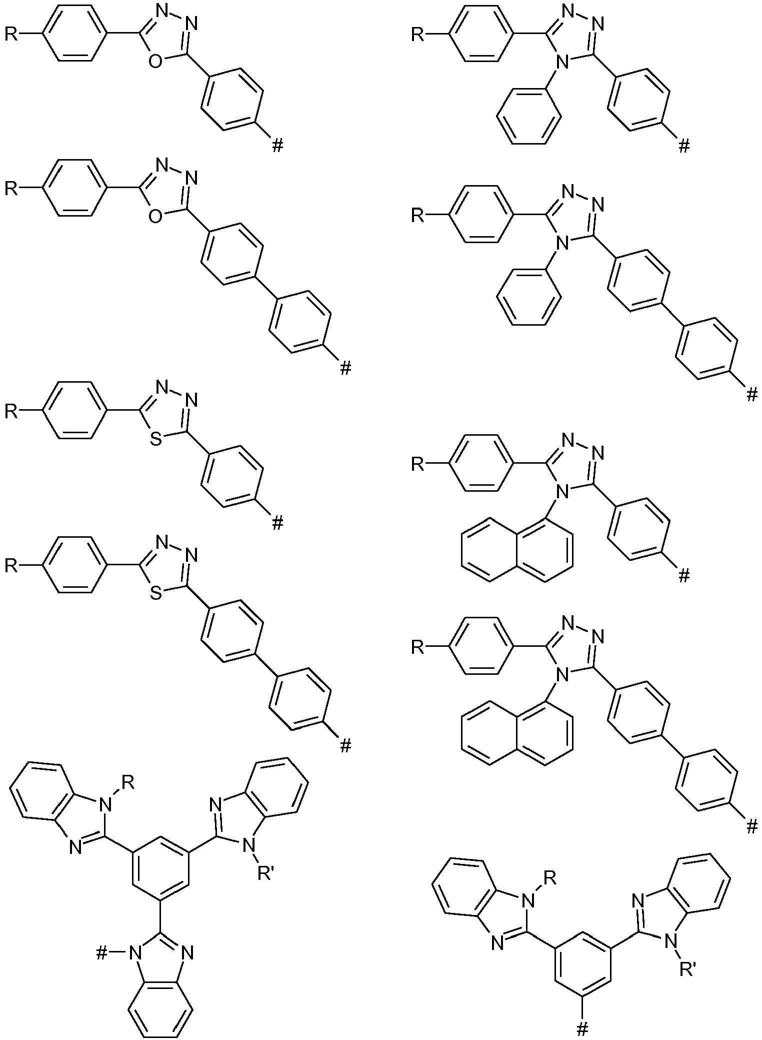

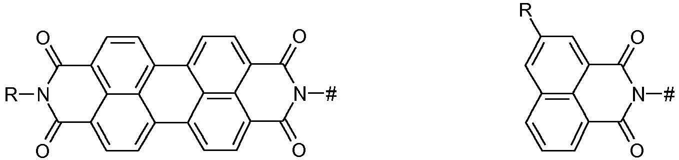

Bei den Substituenten R und R' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR'"₃) oder Ethergruppen -OR'" (R"' definiert wie R; die hier verwendeten Substituenten entsprechen nicht notwendiger Weise den Substituenten R und/oder R' der Formel A oder der Formeln I bis oder IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den E∩D-Liganden am einfachsten durch Palladiumkatalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

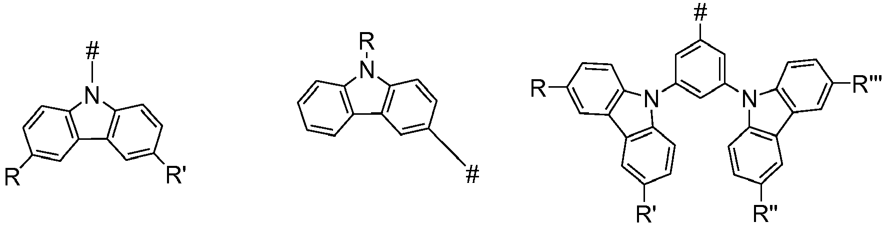

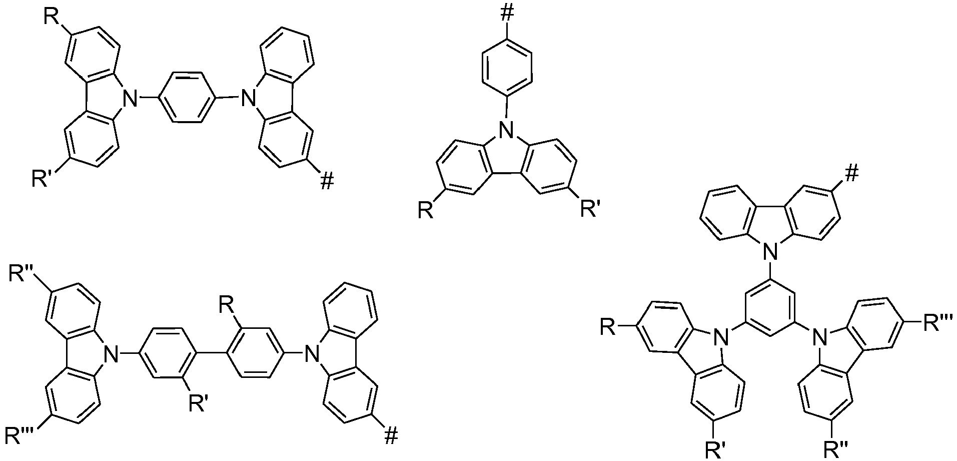

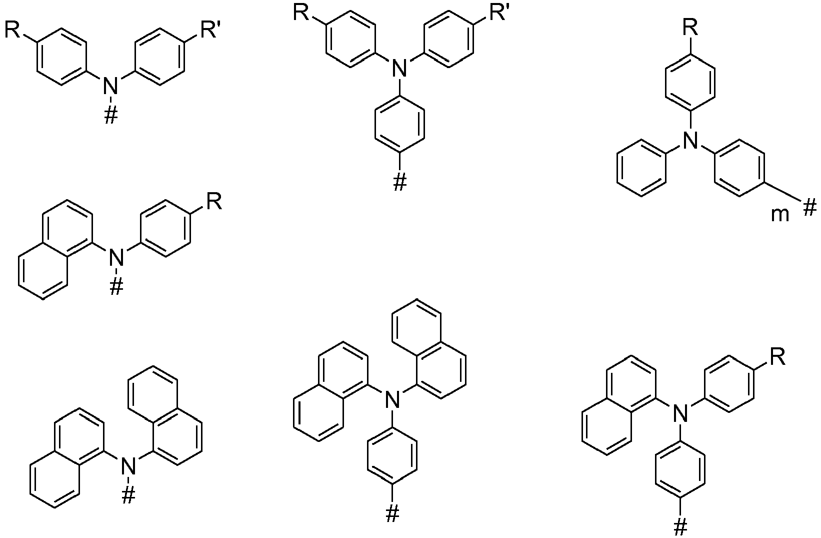

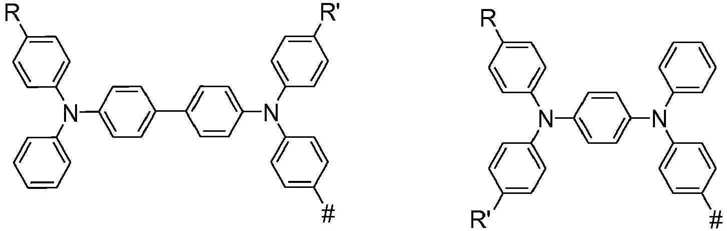

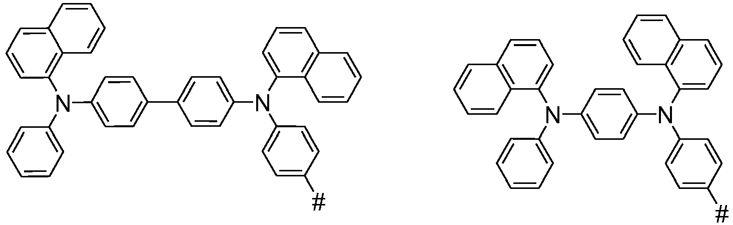

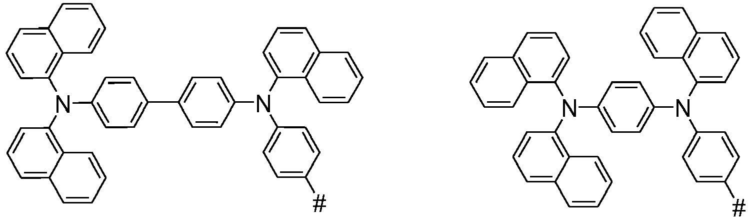

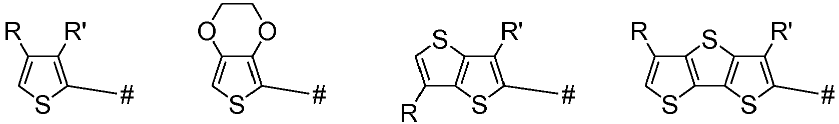

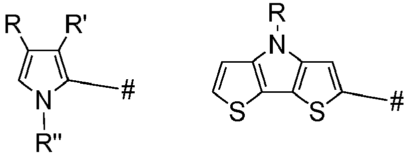

Bei den oben gezeigten Substituenten R, R" und R'" handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""₃) oder Ethergruppen -OR"" (R"" definiert wie R; die oben für die Lochtransport-Substituenten verwendeten Substituenten entsprechen nicht notwendiger Weise den Substituenten R und/oder R' der Formel A oder der Formeln I bis IX) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

Zur Verwendung der Metall(I)-Komplexe als selbstkatalysierende Emittermaterialien zur Erzielung einer Quervernetzung mit einem zweiten Reaktanden können solche Funktionalitäten in der Peripherie des E∩D-Liganden angebracht werden, die mit der entsprechend komplementären funktionellen Einheit des zweiten Reaktanden eine durch den Metall(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.

Beispielhaft für eine selbstkatalysierte Quervernetzungsreaktion ist die Kupfer-katalysierte Click-Reaktion zwischen einem terminalen oder aktivierten Alkin als erster Click-Gruppe und einem Azid als zweiter Click-Gruppe. Da der Metallkomplex-Emitter in dieser Ausführungsform mindestens zwei Alkin-Einheiten tragen muss, sind mindestens zwei der Einheiten D, E, Q, Y, Z in bevorzugter Weise mit mindestens je einer der oben genannten funktionellen Gruppe zur Erzielung einer Quervernetzung substituiert, während die für die Quervernetzung nicht aktiven übrigen Einheiten D, E, Q, Y, Z, die nicht mit mindestens je einer der oben genannten funktionellen Gruppe zur Erzielung einer Quervernetzung substituiert sind, optional mit einer anderen der oben genannten funktionellen Gruppe zur Erhöhung der Löslichkeit des Komplexes in organischen Lösungsmitteln und/oder zur Verbesserung des Ladungsträgertransports substituiert sein kann.

Somit können unterschiedliche Funktionalitäten über die Peripherie der verschiedenen Liganden eingeführt werden (beispielsweise je eine Lochtransport- und Elektrontransport-Einheit zur Erzielung eines optimalen Ladungsträgertransports und/oder ein Substituent zur Erhöhung der Löslichkeit des Komplexes in organischen Lösungsmitteln und/oder eine funktionelle Gruppe zur Erzielung einer Quervernetzung), wodurch eine sehr flexible Anpassung und Modifizierung der Metall(I)-Komplexe möglich ist.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R¹-R⁸ so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R¹-R⁸ erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ (n = 2 - 500). Weitere unpolare Gruppen sind: Ether -OR*, Thioether -SR*, unterschiedlich substituierte Silane R*₃Si-(R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O)ₙ- (n > 20); Oligo/polyphosphazene R**(-R*₂P=N-)ₙ- (n = 1 - 200).

### Löslichkeit in polaren Medien

Polare Substitutenten R¹-R⁸ erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze): -COOH, -P(O)(OH)₂ , -P(S)(OH)₂ , -S(O)(OH)₂ , -COOR*, -P(O)(OR*)₂ , -P(S)(OR*)₂ ,-S(O)(OR*)₂, -CONHR*, -P(O)(NR*₂)₂, -P(S)(NR*₂)₂, -S(O)(NR*₂)₂
- Sulfoxide: -S(O)R*, -S(O)₂R*
- Carbonylgruppen: -C(O)R*
- Amine: -NH₂, -NR*₂, -N(CH₂CH₂OH)₂,
- Hydroxylamine =NOR*
- Oligoester, -O(CH₂O-)ₙ, -O(CH₂CH₂O-)ₙ (n = 2 - 200)
- Positiv geladene Substituenten: z. B. Ammonium-Salze -N⁺R*₃X⁻ , Phosphonium-Salze-P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Optional kann das Darstellungsverfahren den Schritt umfassen, dass mindestens ein Ligand E∩D mit mindestens einem der oben genannten Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass mindestens ein Ligand E∩D mit mindestens einer der o. g. funktionellen Gruppe zur Verbesserung des Ladungsträgertransports substituiert wird, wobei die funktionelle Gruppe an einem Ligand E∩D gleich oder verschieden sein kann von der funktionellen Gruppe am anderen Ligand, bevorzugt verschieden, wobei der Substituent in einer Ausführungsform der Erfindung ausgewählt sein kann aus der Gruppe bestehend aus Elektronenleiter und Lochleiter.

Erfindungsgemäß sind auch Metall(I)komplexe, die durch ein derartiges Syntheseverfahren herstellbar sind.

Die Metall(I)komplexe der Formel A können erfindungsgemäß als Emitter-Materialien in einer Emitterschicht eines Licht-emittierenden optoelektronischen Bauelements eingesetzt werden.

Die Metall(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Metall(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Metall(I)komplexes in der Emitter- oder Absorber-Schicht 1 % bis 99 %.

Vorteilhafter Weise beträgt die Konzentration des Metall(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen Metall(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Weiterhin betrifft die vorliegende Erfindung ein Verfahren zur Herstellung eines optoelektronischen Bauelements, wobei ein erfindungsgemäßer Metall(I)komplex der hier beschriebenen Art verwendet wird. Bei diesem Verfahren wird insbesondere ein erfindungsgemäßer Metall(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Metall(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Metall(I)komplex ein erfindungsgemäßer Metall(I)komplex ist. Erstes und zweites Lösungsmittel sind dabei nicht identisch.

Die vorliegende Erfindung betrifft auch die Verwendung eines erfindungsgemäßen Metall(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Metall(I)komplex.

Da die erfindungsgemäßen Metall(I)komplexe mit unsubstituierten Liganden E∩D in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan-, Arsan- oder Antimon-Liganden unter diesen Bedingungen nicht ausgeschlossen werden. Daher ist nicht klar, ob die Substanzen bei einer Abscheidung auf dem Substrat als M₂X₂(E∩D)₂ kristallisieren bzw. ob sie in der Matrix in dieser Form molekular vorliegen werden. Aus diesem Grund sollten die Substanzen in einer für die Anwendung in optoelektronischen Bauelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Metall(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Metall(I)komplexe (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Um die Löslichkeit der erfindungsgemäßen Metall(I)komplexe in organischen Lösungsmitteln zu verbessern, ist mindestens eine der Strukturen E∩D in bevorzugter Weise mit mindestens einem der oben genannten Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3 bis 50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfmsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C3-Einheit, verzweigt oder unverzweigt oder zyklisch, erreicht.

Um den Ladungsträgertransport zu den erfindungsgemäßen Metall(I)komplexen zu verbessern, ist mindestens eine der Strukturen E∩D in bevorzugter Weise mit mindestens einer der oben genannten funktionellen Gruppe zur Verbesserung des Ladungsträgertransports substituiert, wobei die funktionelle Gruppe an einem Ligand E∩D gleich oder verschieden sein kann von der funktionellen Gruppe am anderen Ligand, bevorzugt verschieden. Der Substituent kann ausgewählt sein aus der Gruppe bestehend aus Elektronenleiter und Lochleiter.

Die Substituenten der Strukturen E∩D der Metall(I)komplexe können an jeder Stelle der Struktur angeordnet sein.

Ein weiterer Aspekt der Erfindung betriff die Veränderung der Emissionsfarben der Metall(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
-Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)₂, -S-Alkylgruppe

Beispiele für elektronenziehende Substituenten sind insbesondere:
-Halogen, -(CO)H, -(CO)-Alkylgruppe, -(CO)O-Alkylgruppe, -(CO)OH, -(CO)Halogenid, -CF₃, -CN, -SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt.

Somit kann durch geeignete Substitutionswahl innerhalb der Grundstruktur eines E∩D-Liganden ein sehr breiter Emissionsfarbbereich eingestellt werden.

Die Veränderung der Emissionsfarben der hier beschriebenen Metall(I)komplexe kann auch durch weitere Heteroatome wie N, O, S, sowie mittels kondensierter Aromaten erfolgen.

Die Verwendung kondensierter Aromaten wie beispielsweise Naphthyl, Anthracenyl, Phenanthrenyl etc. ermöglicht Farbverschiebungen, zum Beispiel in den gelben bis tiefroten Spektralbereich. Die Erhöhung der Löslichkeit von Metall(I)komplexen mit kondensierten Aromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Metall(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von den Koordinationsstellen des Liganden E∩D.

Für die Herstellung der oben genannten Nanopartikel kleiner als 30 nm können mehrere Techniken angewandt werden:^{[xxii]}

*Bottom-Up-*Prozesse zur Synthese von Nanopartikeln:
- schnelle Injektion der Reaktionslösung in einen großen Überschuss eines geeigneten Fällungsmittel (z. B. Pentan, Diethylether).^{[xxiii]}
- Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
- Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
- Co-Abscheidung der Komplexe und des Matrixmaterials auf dem Substrat direkt aus der Reaktionslösung.
- Synthese im Ultraschall-Bad.

*Top-Down*-Prozesse zur Zerkleinerung der Substanzen:
- Zerkleinerung durch Hochenergiekugelmühlen.^{[xxiv]}
- Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen auch als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

**Figuren**
- **Figur 1:**: Prinzipieller Aufbau eines OLEDs. Die Abbildung ist nicht maßstabsgerecht gezeichnet.
- **Figur 2:**: Festkörperstruktur von **1b.**
- **Figur 3:**: Emissionsspektren der festen, kristallinen Proben von **1a** - **1c** (Anregung bei 350 nm).
- **Figur 4:**: Berechnete Grenzorbitale des Grundzustands von **1b.**
- **Figur 5:**: Emissionsspektren der festen, kristallinen Proben von **2a - 2d** (Anregung bei 350 nm).
- **Figur 6:**: Emissionsspektren der festen, kristallinen Proben von **9a - 9c** (Anregung bei 350 nm).
- **Figur 7:**: Emissionsspektren einer festen, kristallinen Probe **9c** und im Verglich eines Filmes von **9c** (pur gelöst in Toluol) (Anregung bei 350 nm)
- **Figur 8:**: Elektrolumineszenzspektrum von **9a** in einer OLED (ITO/PEDOT:PSS/HTL / Emitter **9a** in Matrix / ETL / Kathode).
- **Figur 9:**: Strom-Spannungs-Charakteristik und Helligkeit von **9a** in einer OLED (ITO/PEDOT:PSS/HTL / Emitter **9a** in Matrix / ETL / Kathode).
- **Figur 10:**: Emissionsspektrum der festen, kristallinen Proben von **10c** (Anregung bei 350 nm).
- **Figur 11:**: Emissionsspektren der festen, kristallinen Proben von **11a - 11c** (Anregung bei 350 nm).
- **Figur 12:**: Emissionsspektrum der festen, kristallinen Proben von **12c** (Anregung bei 350 nm).
- **Figur 13:**: Emissionsspektrum der festen, kristallinen Proben von **13c** (Anregung bei 350 nm).
- **Figur 14:**: Emissionsspektren der festen, kristallinen Proben von **14a - 14c** (Anregung bei 350 nm).
- **Figur 15:**: Emissionsspektrum der festen, kristallinen Proben von **15c** (Anregung bei 350 nm).

### Beispiele

In den hier gezeigten Beispielen ist der zweizähnige E∩D-Ligand der allgemeinen Formel A ein Amin-Phosphinligand (mit E = PPh₂ und D = NMe₂ bzw. E = PPh₂ und D = N(CH₂)₄), ein Amin-Thioetherligand (mit E = SPh und D = NMe₂), ein Phosphin-Carbenligand (mit E = PPh₂ und D = C*), ein Amin-Carbenligand (mit E = NMe₂ und D = C*) oder ein Thioether-Carbenligand (mit E = SPh und D = C*).

Die gestrichelt gezeichnete Doppelbindung im Carbenliganden bedeutet, dass entweder nur eine Einfachbindung vorliegt und somit ein Imidazolidin-Carben verwendet wird, oder dass alternativ eine Doppelbindung vorliegt und somit ein Imidazol-Carben eingesetzt wird.

### Beispiele für Komplexe der Form M₂X₂(E∩D)₂

### I. E∩D = Ph₂PMe₂NBenzyl, X = Cl, Br, I: Cu₂Cl₂(Ph₂PMe₂NBenzyl)₂ (1a), Cu₂Br₂(Ph₂PMe₂NBenzyl)₂ (1b), Cu₂I₂(Ph₂PMe₂NBenzyl)₂ (1c)

Bei den Verbindungen **1a-c** handelt es sich um gelbe, feinkristalline Feststoffe.

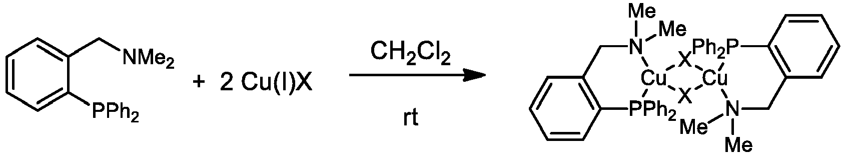

Charakterisierung:
- **1a:**: ¹H-NMR (CDCl₃): δ 7.75 - 7.02 (m, Ar-H, 28 H), 3.41(bs, CH₂, 4 H), 2.33 (bs, NMe₂,12 H) ppm.
³¹P-NMR (CDCl₃): -21 ppm.
EA C₄₂H₄₄Cu₂Cl₂N₂P₂ (834.09): ber.: C 60.29; H 5.30, N 3.35
gef.:C60.10;H5.51,N3.12
- **1b:**: ¹H-NMR (CDCl₃): δ 7.66 - 7.20 (m, Ar-H, 28 H), 3.47 (bs, CH₂, 4 H), 2.42 (bs, NMe₂, 12 H) ppm.
³¹P-NMR (CDCl₃): -20 ppm.
IR (ATR): 3045 (vw), 2998 (vw), 2825 (vw), 1585 (vw), 1461 (w), 1434 (w), 1370 (w),
1309 (vw), 1242 (vw), 1173 (vw), 1128 (vw), 1096 (s), 1035 (w), 1000 (s), 880 (vw), 836 (s), 752 (vs), 744 (vs), 694 (vs), 621 (w), 518 (vs), 489 (vs), 451 (m), 436 (s) cm⁻¹
FAB-MS 926 [M]⁺, 845 [Cu₂BrL₂]⁺, 526 [Cu₂BrL]⁺, 463 [CuBrL]⁺, 383 [CuL]⁺.
EA C₄₂H₄₄Cu₂Br₂N₂P₂ (921.99): ber.: C 54.50; H 4.79; N 3.03
gef.: C 54.30; H 4.85; N 2.82
- **1c:**: ¹H-NMR (CDCl₃): δ 7.72 - 7.10 (m, Ar-H, 28 H), 3.45(bs, CH₂, 4 H), 2.40 (bs, NMe₂,
12 H) ppm.
³¹P-NMR (CDCl₃): -18 ppm.
IR (ATR): 2823 (vw), 1568 (vw), 1476 (w), 1454 (w), 1432 (m), 1359 (vw), 1305 (vw), 1203 (vw), 1162 (vw), 1125 (vw), 1093 (m), 997 (m), 984 (m), 886 (w), 836 (s), 761 (vw), 744 (vs), 692 (vs), 619 (vw), 530 (m), 509 (vs), 490 (vs), 454 (vs), 426 (vs) cm⁻¹ FAB-MS 1022 [Cu₂I₂L₂]⁺, 892 [Cu₂IL]⁺, 505 [CuIL]⁺.
EA C₄₂H₄₄Cu₂I₂N₂P₂ (1017.97): ber.: C 49.47; H 4.35; N, 2.75
gef.: C 49.36; H 4.40; N 2.53

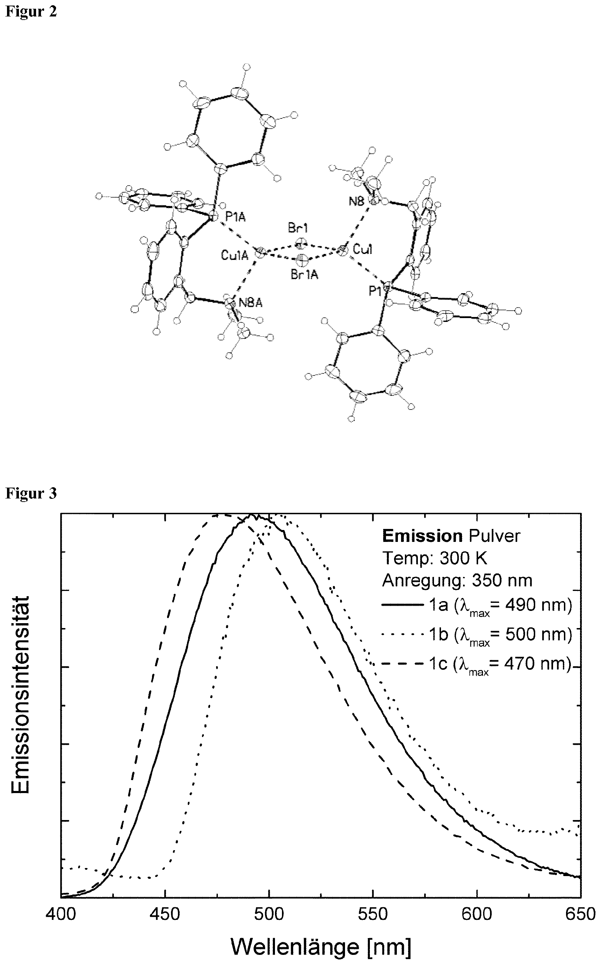

Die Kristallstruktur ist in Fig. 2 **(1b)** dargestellt.

Die Emissionsspektren von **1a - 1c** sind in Fig. 3 gezeigt.

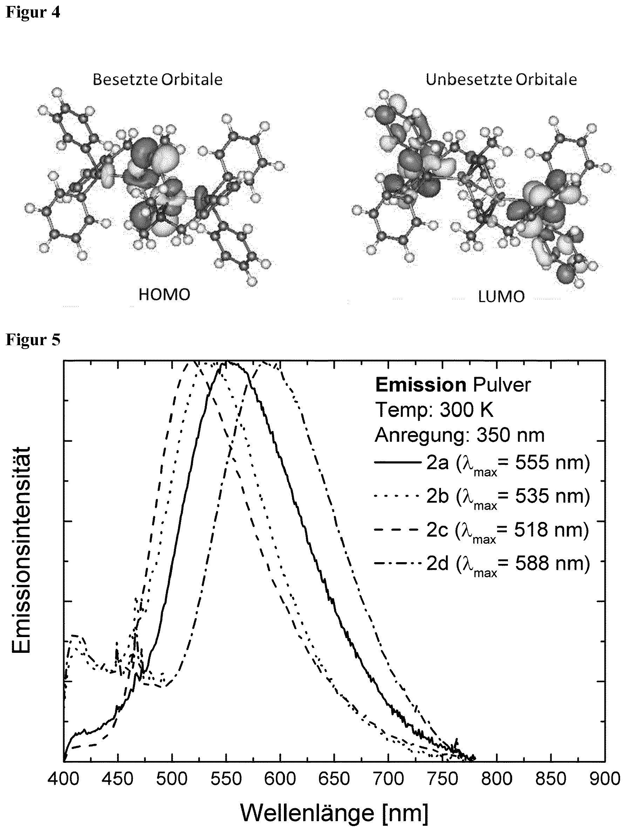

Die berechneten Grenzorbitale des Grundzustand von **1b** sind in Fig. 4 gezeigt.

### II. E∩D = Ph₂PMe₂NNaphtyl, X = Cl, Br, I, CN: Cu₂Cl₂(Ph₂PMe₂NNaphtyl)₂ (2a), Cu₂Br₂(Ph₂PMe₂NBenzyl)₂ (2b), Cu₂I₂(Ph₂PMe₂NBenzyl)₂ (2c), Cu₂CN₂(Ph₂PMe₂NBenzyl)₂ (2d),

Bei den Verbindungen **2a-d** handelt es sich um weiße, feinkristalline Feststoffe.

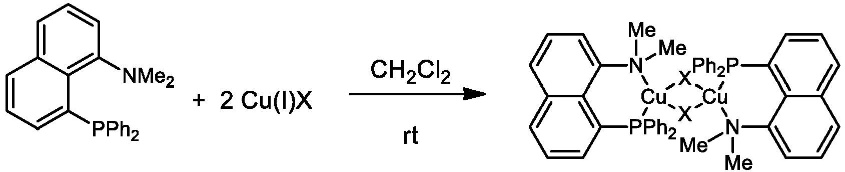

Charakterisierung:
Elementaranalyse:
   - **2a:**: Summenformel: C₄₈H₄₄Cl₂Cu₂N₂P₂ · ½ H₂O
   ber.: C 62.20; H 5.00; N 3.02
   gef.: C 62.02; H 4.71; N 2.87
   - **2b:**: Summenformel: C₄₈H₄₄Br₂Cu₂N₂P₂
   ber.: C 57.78; H 4.45; N 2.81
   gef.: C 57.61; H 4.36; N 2.64
   - **2c:**: Summenformel: C₄₈H₄₄Cl₂Cu₂N₂P₂
   ber.: C 52.81; H 4.06; N 2.57
   gef.: C 52.60; H 3.93; N 2.34
   - **2d:**: Summenformel: C₅₀H₄₄Cu₂N₄P₂ · ½ H₂O
   ber.: C 66.14; H 5.11; N 6.17
   gef.: C 65.72; H 4.76; N 6.57

Die Emissionsspektren von **2a** - **2d** sind in Fig. 5 gezeigt.

### III. E∩D = Ph₂POMe₂NPhenyl, X = Cl, Br, I: Cu₂Cl₂(Ph₂POMe₂NPhenyl)₂ (3a), Cu₂Br₂(Ph₂POMe₂NPhenyl)₂ (3b), Cu₂I₂(Ph₂POMe₂NPhenyl)₂ (3c)

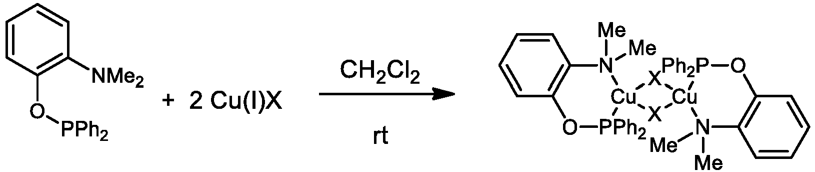

### IV. E∩D = PhSMe₂NBenzyl, X = Cl, Br, I: Cu₂Cl₂(PhSMe₂NBenzyl)₂ (4a), Cu₂Br₂(PhSMe₂NBenzyl)₂ (4b), Cu₂I₂(PhSMe₂NBenzyl)₂ (4c)

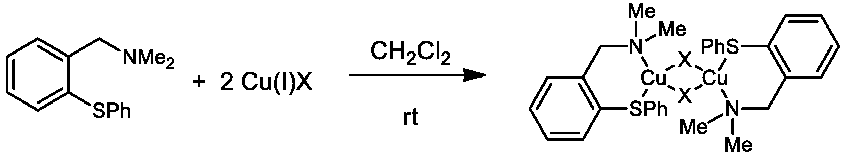

### V. E∩D = Me₂NPhSBenzyl, X = Cl, Br, I: Cu₂Cl₂(Me₂NPhSBenzyl)₂ (5a), Cu₂Br₂(Me₂NPhSBenzyl)₂ (5b), Cu₂I₂(Me₂NPhSBenzyl)₂ (5c)

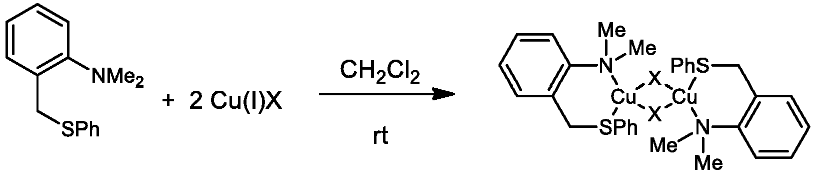

### VI. E∩D = Ph₂PNHCPhenyl, X = Cl, Br, I: Cu₂Cl₂(Ph₂PNHCPhenyl)₂ (6a), Cu₂Br₂(Ph₂PNHCPhenyl)₂ (6b), Cu₂I₂(Ph₂PNHCPhenyl)₂ (6c)

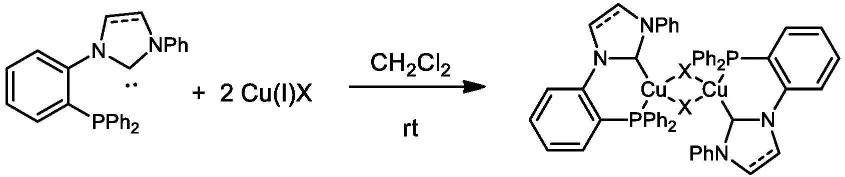

Bevorzugt ist die folgende Reaktion:

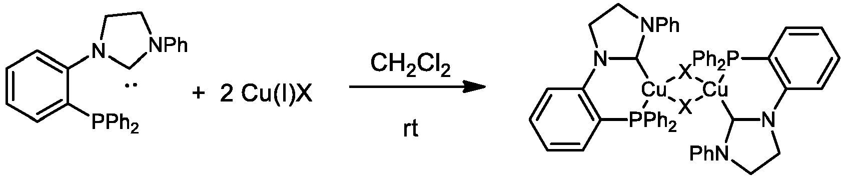

### VII. E∩D - Me₂NNHCPhenyl, X = Cl, Br, I: Cu₂Cl₂(Me₂NNHCPhenyl)₂ (7a), Cu₂Br₂(Me₂NNHCPhenyl)₂ (7b), Cu₂I₂(Me₂NNHCPhenyl)₂ (7c)

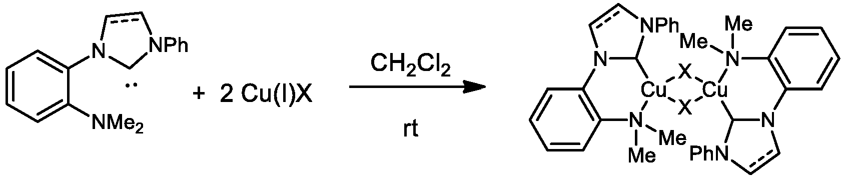

Bevorzugt ist die folgende Reaktion:

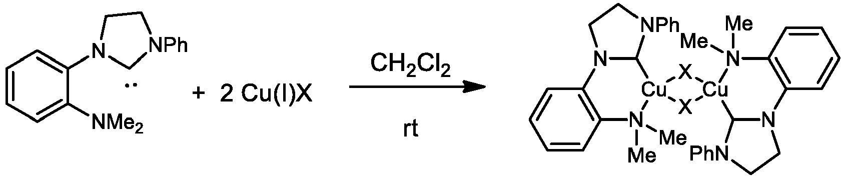

### VIII. E∩D = PhSNHCPhenyl, X = Cl, Br, I: Cu₂Cl₂(PhSNHCPhenyl)₂ (8a), Cu₂Br₂(PhSNHCPhenyl)₂ (8b), Cu₂I₂(PhSNHCPhenyl)₂ (8c)

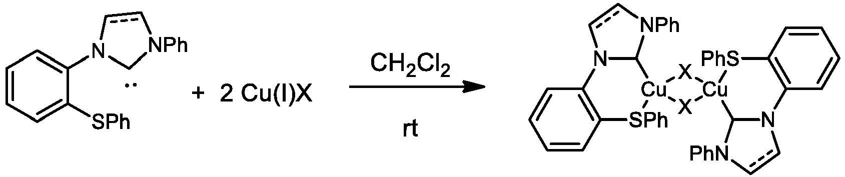

Bevorzugt ist die folgende Reaktion:

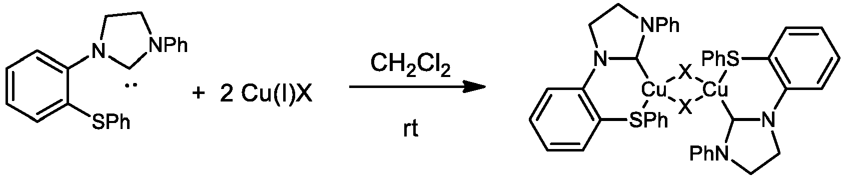

### IX. E∩D = Ph₂P(CH₂)₄NBenzyl, X = Cl, Br, I: Cn₂Cl₂(Ph₂P(CH₂)₄NBenzyl)₂ (9a), Cu₂Br₂(Ph₂P(CH₂)₄NBenzyl)₂ (9b), Cu₂I₂(Ph₂P(CH₂)₄NBenzyl)₂ (9c)

Bei den Verbindungen **9a-c** handelt es sich um feinkristalline Feststoffe.

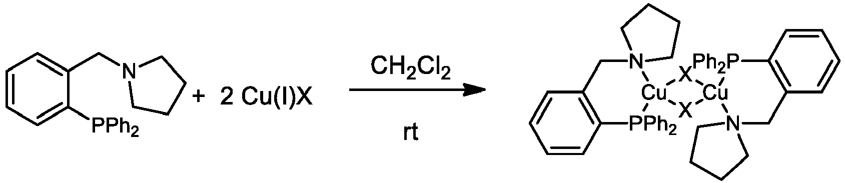

Die vorliegenden Verbindungen wurden mittels 1H und 31P NMR Spektroskopie charakterisiert und ihre Struktur durch Vergleich mit den durch Röntgenbeugung bestätigten, verwandten Strukturen **1a-c** bestimmt.
- **9a:**: ¹H-NMR (CDCl₃): 1.65 (bs, 4H, NCH₂CH₂), 2.45 (bs, 4H, NCH₂CH₂), 3.40 (bs, 2H, ArCH₂), 7.00 - 8.00 (m, 14H, Ar-H) ppm.
³¹P-NMR (CDCl₃): -22 ppm.
- **9b:**: ¹H-NMR (CDCl₃): 1.72 (bs, 4H, NCH₂CH₂), 2.53 (bs, 4H, NCH₂CH₂), 3.50 (bs, 2H, ArCH₂), 7.00 - 8.00 (m, 14H, Ar-H) ppm.
³¹P-NMR (CDCl₃): -20 ppm.
- **9c:**: ¹H-NMR (CDCl₃): 1.70 (bs, 4H, NCH₂CH₂), 2.52 (bs, 4H, NCH₂CH₂), 3.46 (bs, 2H, ArCH₂), 7.00 - 8.00 (m, 14H, Ar-H) ppm.
³¹P-NMR (CDCl₃): -16 ppm.

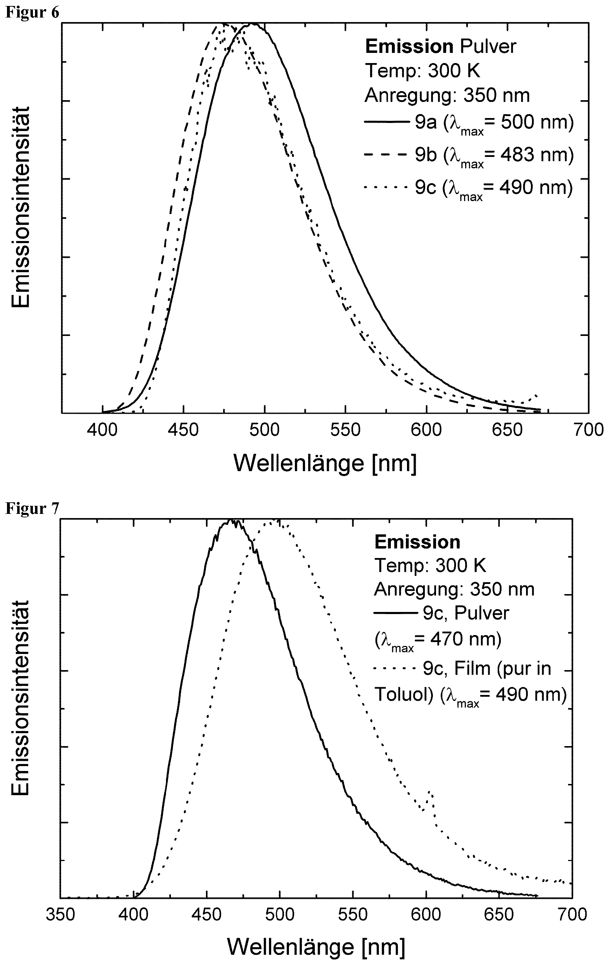

Die Emissionsspektren von **9a - 9c** sind in Fig. 6 gezeigt. Die Emissionsspektren von **9c** im Vergleich als Pulver und als Film (pur in Toluol) sind in Fig. 7 gezeigt.

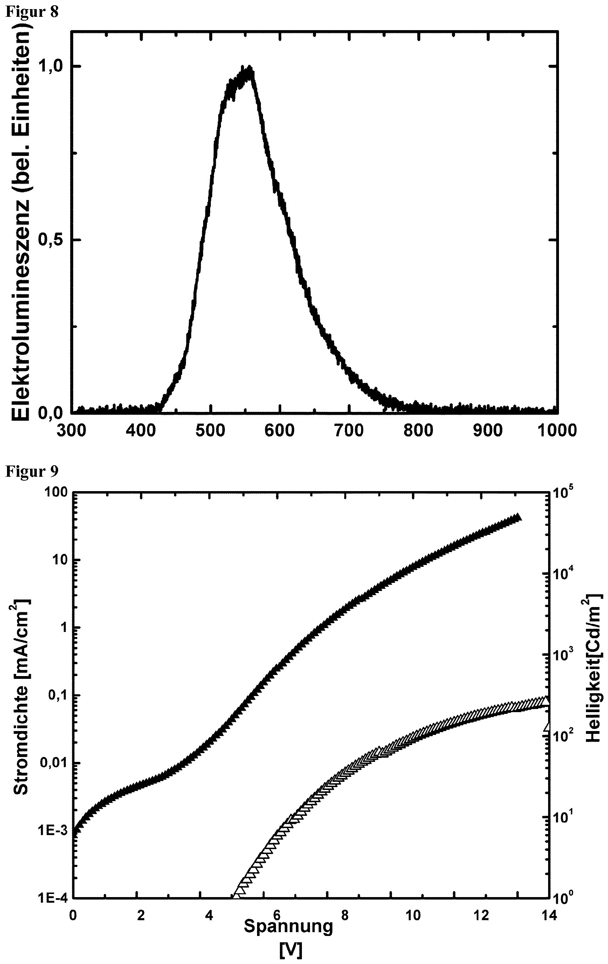

Das Elektrolumineszenzspektrum von **9a** ist in Fig. 8 gezeigt.

Die Strom-Spannungs-Charakteristik sowie die Helligkeit von **9a** ist in Fig. 9 gezeigt.

### X. E∩D = Ph₂P(CH₂)₄NCH₃Benzyl, X = Cl, Br, I: Cu₂Cl₂(Ph₂P(CH₂)₄NCH₃Benzyl)₂ (10a), Cu₂Br₂(Ph₂P(CH₂)₄NCH₃Benzyl)₂ (10b), Cn₂I₂(Ph₂P(CH₂)₄NCH₃Benzyl)₂ (10c)

Bei den Verbindungen **10a-c** handelt es sich um feinkristalline Feststoffe.

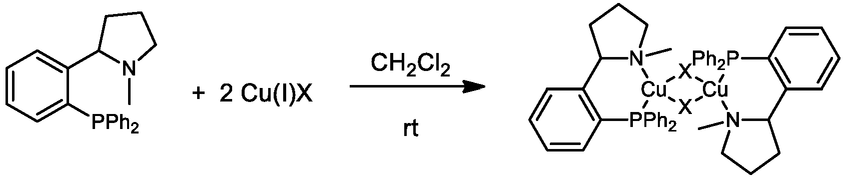

Die vorliegende Verbindung mit X = I wurde mittels 1H und 31P NMR Spektroskopie charakterisiert und ihre Struktur durch Vergleich mit den durch Röntgenbeugung bestätigten, verwandten Strukturen 1a-c bestimmt.

### 10c: ¹H-NMR (CDCl₃): δ = 7.55-7.52 (m, 2H), 7.45-7.28 (m, 11H), 7.11-7.08 (t, 1H), 3.78 (s, 1H), 3.53 (s, 1H), 2.43 (s,34H), 2.40 (s, 1H), 2.05 (m, 1H), 1.85 (m, 1H), 1.69 (m, 2H) ppm. ³¹P-NMR (CDCl₃): -18 ppm.

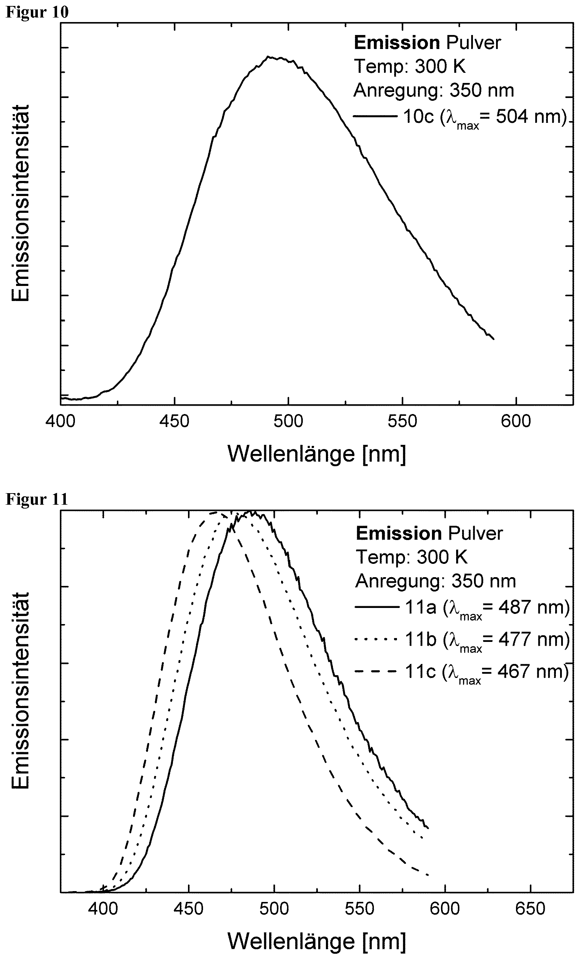

Das Emissionsspektrum von **10c** ist in Fig. 10 gezeigt.

### XI. E∩D = Ph₂PPiperidinNBenzyl, X = Cl, Br, I: Cu₂Cl₂(Ph₂PPiperidinNBenzyl)₂ (11a), Cu₂Br₂(Ph₂PPiperidinNBenzyl)₂ (11b), Cu₂I₂(Ph₂PPiperidinNBenzyl)₂ (11c)

Bei den Verbindungen **11a-c** handelt es sich um feinkristalline Feststoffe.

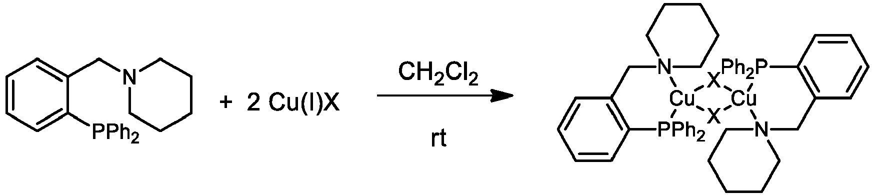

Die vorliegenden Verbindungen mit X = Cl und X = Br wurden mittels 1H und 31P NMR Spektroskopie charakterisiert und ihre Struktur durch Vergleich mit den durch Röntgenbeugung bestätigten, verwandten Strukturen 1a-c bestimmt.
- **11a:**: ¹H-NMR (CDCl₃, 500 MHz) δ = 7.56-7.50 (m, 4H), 7.44-7.33 (m, 6H), 7.32-7.30 (m, 2H), 7.21 (d, 1H), 6.85 (d, 1H), 3.56 (s, 2H), 2.58 (s, 4H), 1.95 (s, 4H), 1.34 (s, 2H) ppm.
³¹P-NMR (CDCl₃): -19 ppm.
- **11b:**: ¹H-NMR (CDCl₃, 500 MHz) δ = 7.57-7.54 (m, 4H), 7.44-7.36 (m, 7H), 7.30-7.25 (m, 2H), 6.98-6-92 (m, 1H), 3.57 (s, 2H), 2.60 (s, 4H), 2.00 (s, 4H), 1.44 (s, 2H) ppm.
³¹P-NMR (CDCl₃): -20 ppm.
- **11c:**: EA: ber.: C 50.06; H 4.38; N, 2.54
gef.: C 49.92; H 4.23; N 2.50

Die Emissionsspektren von **11a** -**11c** sind in Fig. 11 gezeigt.

### XII. E∩D = Ph₂PPiperidinN-meta-Fluor-Benzyl, X = Cl, Br, I: Cu₂Cl₂(Ph₂PPiperidinN-meta-Fluor-Benzyl)₂ (12a), Cu₂Br₂(Ph₂PPiperidinN-meta-Fluor-Benzyl)₂ (12b), Cu₂I₂(Ph₂PPiperidinN-meta-Fluor-Benzyl)₂ (12c)

Bei den Verbindungen **12a-c** handelt es sich um feinkristalline Feststoffe.

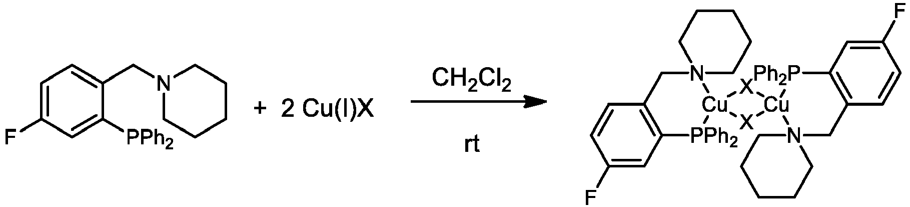

Die vorliegende Verbindung mit X = I wurde mittels 1H und 31P NMR Spektroskopie charakterisiert und ihre Struktur durch Vergleich mit den durch Röntgenbeugung bestätigten, verwandten Strukturen 1a-c bestimmt.
- **12c:**: ¹H-NMR (CDCl₃, 500 MHz) δ = 7.54 (td, 4H), 7.40-7.37 (m, 2H), 7.33-7.30 (m, 4H), 7.25-7.21 (m, 1H), 7.01 (td, 1H), 6.59 (td, 1H), 3.54 (s, 2H), 2.57 (s, 4H), 1.91 (s, 4H), 1.38 (s, 2H) ppm.
³¹P-NMR (CDCl₃): -24 ppm.

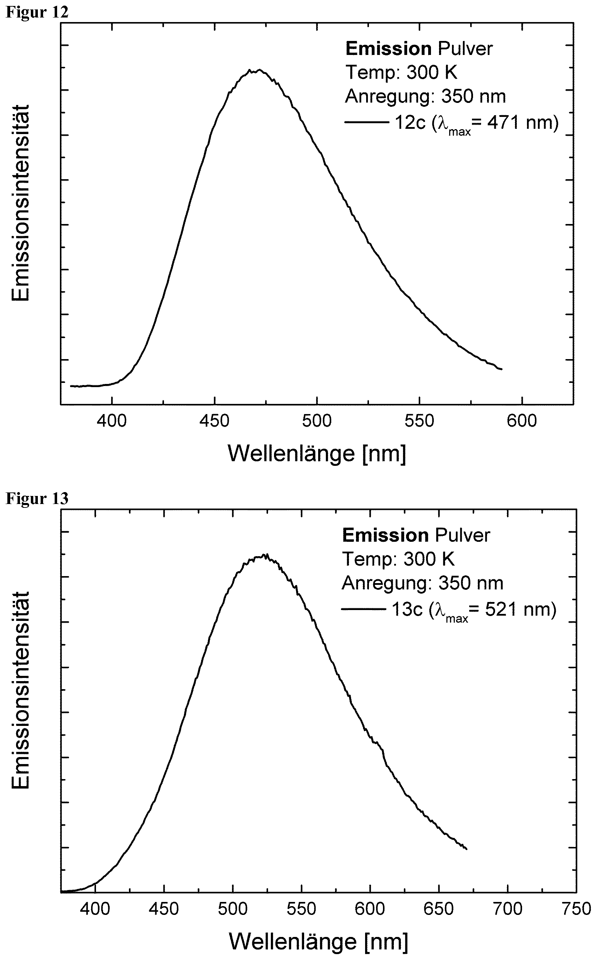

Das Emissionsspektrum von **12c** ist in Fig. 12 gezeigt.

### XIII. E∩D = Ph₂PPiperidinN-meta-Dimethylamino-Benzyl, X = Cl, Br, I: Cu₂Cl₂(Ph₂PPiperidinN-meta-Dimethylamino-Benzyl)₂ (13a), Cu₂Br₂(Ph₂PPiperidinN-meta-Dimethylamino-Benzyl)₂ (13b), Cu₂I₂(Ph₂PPiperidinN-meta-Dimethylamino-Benzyl)₂ (13c)

Bei den Verbindungen **13a-c** handelt es sich um feinkristalline Feststoffe.

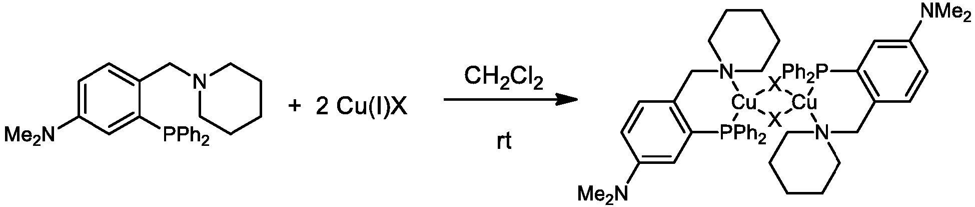

Die vorliegende Verbindung mit X = I wurde mittels 1H und 31P NMR Spektroskopie charakterisiert und ihre Struktur durch Vergleich mit den durch Röntgenbeugung bestätigten, verwandten Strukturen 1a-c bestimmt.
- **13c:**: ¹H-NMR (CDCl₃, 500 MHz) δ = 7.58-7.52 (m, 4H), 7.41-7.33 (m, 6H), 7.07 (dd, 1H), 6.62 (dd, 1H), 6.16 (dd, 1H), 3.48 (s, 2H), 2.72 (s, 6H), 2.58 (s, 4H), 2.00 (s, 4H), 1.49 (s, 2H) ppm.
³¹P-NMR (CDCl₃): -19 ppm.

Das Emissionsspektrum von **13c** ist in Fig. 13 gezeigt.

### XIV. E∩D = Ph₂PMorpholinNBenzyl, X = Cl, Br, I: Cu₂Cl₂(Ph₂PMorpholinNBenzyl)₂ (14a), Cu₂Br₂(Ph₂P-2,6-dimethylmorpholinNBenzyl)₂ (14b), Cu₂I₂(Ph₂PMorpholinNBenzyl)₂ (14c)

Bei den Verbindungen **14a-c** handelt es sich um feinkristalline Feststoffe.

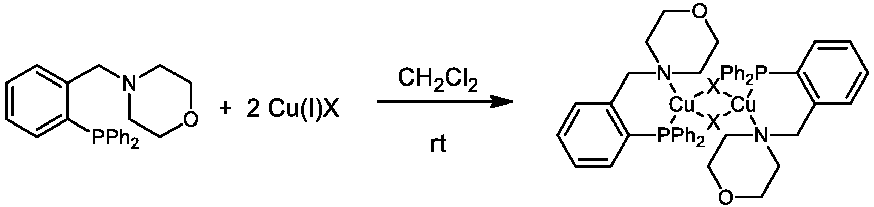

Die vorliegenden Verbindungen wurden mittels 1H und 31P NMR Spektroskopie charakterisiert und ihre Struktur durch Vergleich mit den durch Röntgenbeugung bestätigten, verwandten Strukturen 1a-c bestimmt.
- **14a:**: EA: ber.: C 60.00; H 5.25; N 3.04,
gef.: C 59.55; H 5.10; N 3.08
- **14b:**: EA: ber.: C 54.72; H 4.79, N 2.77,
gef.: C 54.47.55; H 4.70; N 2.89

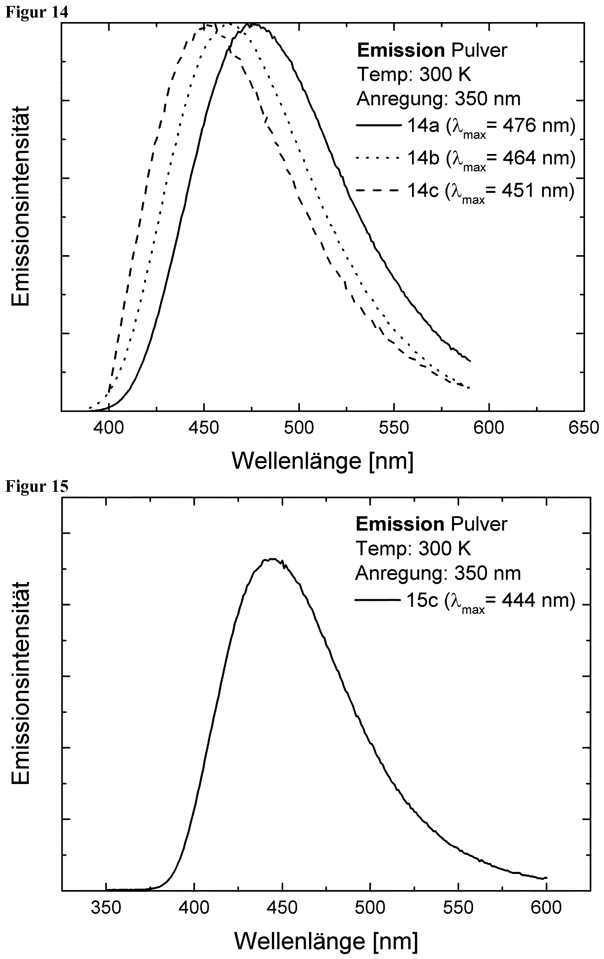

Die Emissionsspektren von **14a -14c** sind in Fig. 14 gezeigt.

### XV. E∩D = Ph₂P-2,6-dimethylmorpholinNBenzyl, X = Cl, Br, I: Cu₂Cl₂(Ph₂P-2,6-dimethylmorpholinNBenzyl)₂ (15a), Cu₂Br₂(Ph₂P-2,6-dimethylmorpholinNBenzyl)₂ (15b), Cu₂I₂(Ph₂P-2,6-dimethylmorpholinNBenzyl)₂ (15c)

Bei den Verbindungen **15a-c** handelt es sich um feinkristalline Feststoffe.

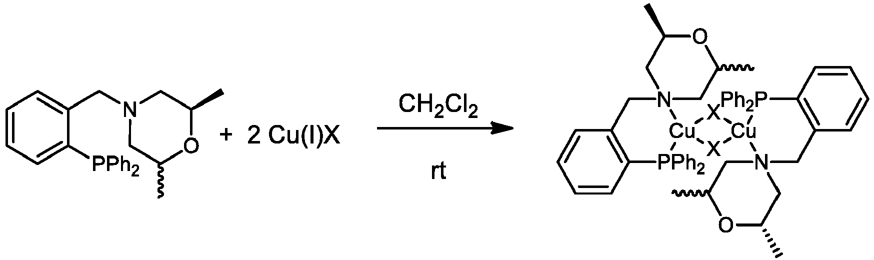

Die vorliegende Verbindung mit X = I wurde mittels 1H und 31P NMR Spektroskopie charakterisiert und ihre Struktur durch Vergleich mit den durch Röntgenbeugung bestätigten, verwandten Strukturen 1a-c bestimmt.
- **15c:**: ¹H-NMR (CDCl₃, 500 MHz) δ = 7.56-7.53 (m, 4H), 7.39-7.35 (m, 3H), 7.31-7.27 (m, 6H), 6.90 (td, 1H), 4.49 (m, 2H), 3.60 (s, 2H), 3.07 (d, 2H), 1.77-1.73 (m, 2H), 1.02 (s, 3H), 1.01 (s, 3H) ppm.
³¹P-NMR (CDCl₃): -24 ppm.

Das Emissionsspektrum von **15c** ist in Fig. 15 gezeigt.

### XVI. E∩D = Me₂C₄H₆PPhenylenOPhosphinoxid, X = Cl, Br, I: Cu₂Cl₂(Me₂C₄H₆PPhenylen-OPhosphinoxid)₂ (16a), Cu₂Br₂(Me₂C₄H₆PPhenylenOPhosphinoxid)₂ (16b), Cu₂I₂(Me₂C₄H₆-PPhenylenOPhosphinoxid)₂ (16c)

Bei den Verbindungen **16a**-**c** handelt es sich um feinkristalline Feststoffe.

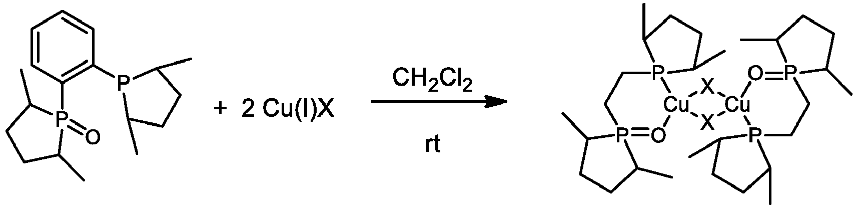

Die vorliegenden Verbindungen mit X = Br und X = I wurden mittels 1H und 31P NMR Spektroskopie; sowie Massenspektroskopie charakterisiert und ihre Struktur durch Vergleich mit den durch Röntgenbeugung bestätigten, verwandten Strukturen 1a-c bestimmt.
- **16b:**: ¹H-NMR (CDCl₃, 500 MHz) δ 7.62 (ddd, *J* = 31.4, 23.9, 7.2 Hz, 6H), 2.92 - 2.68 (m, 5H), 2.51 - 2.21 (m, 9H), 1.98 - 1.79 (m, 3H), 1.74 (s, 2H), 1.67 (d, *J* = 11.7 Hz, 1H), 1.55 - 1.25 (m, 16H), 0.94 (dtd, *J* = 37.5, 15.4, 13.4, 7.0 Hz, 11H).
³¹P-NMR (CDCl₃, 202 MHz): δ 73.46, 19.83.
FAB-MS 932 [M]+, 851 [Cu2BrL2]+, 707 [CuL2]+, 466 [CuBrL]+, 385 [CuL]+.
- **16c:**: ¹H-NMR (CDCl₃, 500 MHz) δ 7.67 (ddd, *J* = 8.1, 5.3, 2.2 Hz, 2H), 7.61 - 7.48 (m, 4H), 7.41 - 7.32 (m, 2H), 2.86 (qdd, *J* = 16.7, 8.3, 4.9 Hz, 6H), 2.42 - 2.11 (m, 11H), 1.83 (qdd, *J* = 12.8, 5.3, 3.1 Hz, 2H), 1.75 -1.62 (m, 2H), 1.55 - 1.24 (m, 16H), 1.02 - 0.83 (m, 12H).
³¹P-NMR (CDCl₃, 202 MHz): δ 71.76, 9.22.
Elementaranalyse gef.: C 41.92, H 5.52
FAB-MS: 1088 [M]+, 899 [Cu2BrL2]+, 707 [CuL2]+, 577 [Cu2IL]+, 512 [CuIL]+, 385 [CuL]+.

### Referenzen

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys. Lett. 2004, 84, 2476.
[iii] J. Shinar (Hrsg.), Organic light-emitting devices - A survey, AIP-Press, Springer, New York, 2004**.**
[iv] H. Yersin, Top. Curr. Chem. 2004, 241, 1.
[v] H. Yersin, Highly Efficient OLEDs with Phosphorescent Materials, Wiley-VCH, Weinheim 2008**.**
[vi] Z. H. Kafafi, Organic Electroluminescence, Taylor & Francis, Boca Raton, 2005**.**
[vii] M. E. Thompson, P. I. Djurovich, J. Li (University of Southern California, Los Angeles, CA), WO 2004/017043 A2, 2004**.**
[viii] M. E. Thompson, P. I. Djurovich, R. Kwong (University of Southern California, Los Angeles, CA, Universal Display Corp, Ewing, NY), WO 2004/016711 A1, 2004**.**
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003**.**
[x] C.-M. Che, US 2003/0205707 A1, 2003**.**
[xi] C.-M. Che, W. Lu, M. C.-W. Chan, US 2002/0179885 A1, 2002**.**
[xii] J. Kamatani, S. Okada, A. Tsuboyama, T. Takiguchi, S. Igawa, US 2003/186080 A1, 2003**.**
[xiii] P. Stößel, I. Bach, A. Büsing (Covion Organic Semiconductors GmbH), DE 10350606 A1, 2005**.**
[xiv] M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005**.**
[xv] C. Lennartz, A. Vogler, V. Pawlowski (BASF AG), DE 10358665 A1, 2005**.**
[xvi] B. Hsieh, T. P. S. Thoms, J. P. Chen (Canon KK, Tokyo), US 2006/989273 B2, 2006**.**
[xvii]N. Schulte, S. Heun, I. Bach, P. Stoessel, K. Treacher (Covion Organic Semiconductors), WO 2006/003000 A1, 2006**.**
[xviii] A. Vogler, V. Pawlowski, H.-W. Schmidt, M. Thelakkat (BASF AG), WO 2006/032449 A1, 2006**.**
[xix] T. K. Hatwar, J. P. Spindler, R. H. Young (Eastman Kodak Co), WO 2006/028546 A1, 2006**.**
[xx] P. C. Ford, E. Cariati, J. Bourassa, Chem. Rev. 1999, 99, 3625.
[xxi] H. Araki, K. Tsuge, Y. Sasaki, S. Ishizaka, N. Kitamura, Inorg. Chem. 2007, 46, 10032.
[xxii] A. Rössler, G. Skillas, S. E. Pratsinis, Chemie in unserer Zeit 2001, 35, 32.
[xxiii] Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738.
[xxiv] Y. Chen, J. F. Gerald, L. T. Chadderton, L. Chaffron, Appl. Phys. Lett. 1999, 74, 2782.

## Patentansprüche

1. Metall(I)komplex aufweisend eine Struktur der Formel A 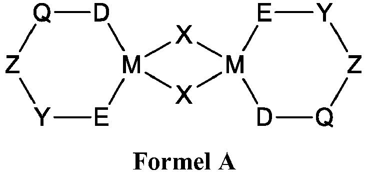 mit
M = unabhängig voneinander ausgewählt aus der Gruppe bestehend aus Cu und Ag;
X = unabhängig voneinander ausgewählt aus der Gruppe bestehend aus Cl, Br, I, CN, OCN, SCN, Alkinyl und N₃;
E∩D = unabhängig voneinander ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD* (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind;
"∩" = eine dreiteilige Einheit aus Q, Y und Z, die miteinander verbunden sind und unabhängig voneinander ausgewählt sind aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind.
wobei optional E∩D mindestens einen Substituenten zur Verbesserung des Ladungsträgertransports und/oder zur Erhöhung der Löslichkeit des Metall(I)komplexes in einem organischen Lösungsmittel aufweist.

2. Metall(I)komplex nach Anspruch 1, aufweisend eine Struktur der Formeln I bis IX 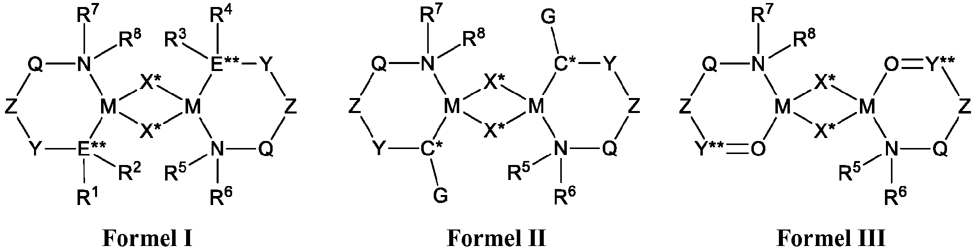 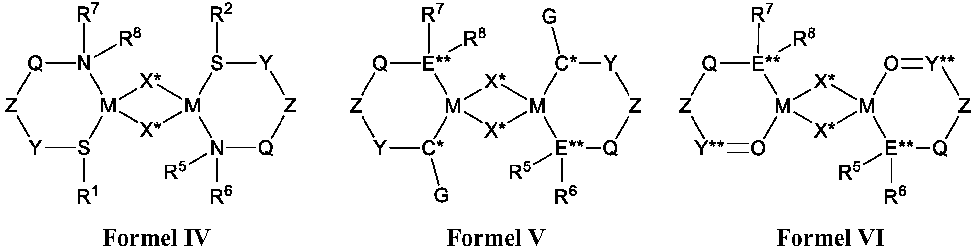 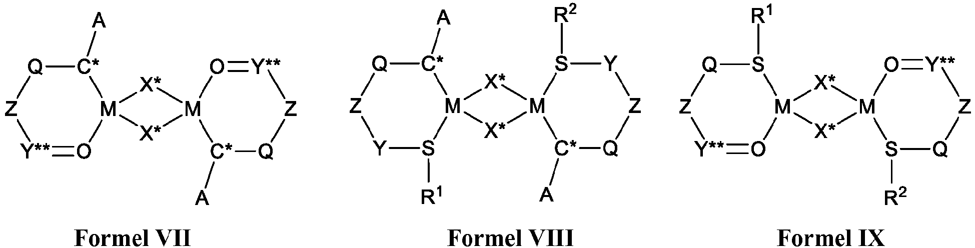 mit:
X* = unabhängig voneinander ausgewählt aus der Gruppe bestehend aus Cl, Br, I, CN, OCN, SCN, Alkinyl und N₃;
M = unabhängig voneinander ausgewählt aus der Gruppe bestehend aus Cu und Ag;
E** = unabhängig voneinander ausgewählt aus der Gruppe bestehend aus P, As und Sb;
C* = ein divalentes Carben-Kohlenstoffatom;
A und G = unabhängig voneinander Substituenten ausgewählt aus der Gruppe bestehend aus NRR', OR, SR und PRR' sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Y** = unabhängig voneinander ausgewählt aus der Gruppe bestehend aus CR, N, PRR', SR, S(O)R;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ = jeweils unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei die Reste R¹-R⁸ optional zu annelierten Ringsystemen führen.

3. Metall(I)komplex nach Anspruch 1 oder 2, wobei die Einheit QC*A unabhängig voneinander ausgewählt ist aus der Gruppe bestehend aus 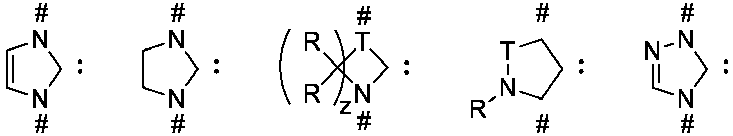 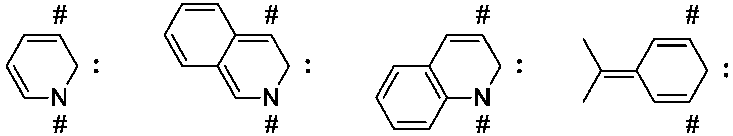 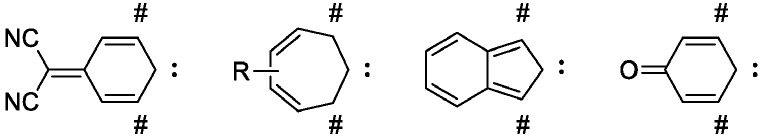 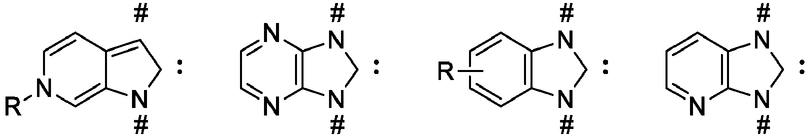 wobei
die zwei Punkte ":" für ein divalentes Carben-Kohlenstoffatom stehen, das an das Metall koordiniert, und die Verknüpfung von Q mit Z an einer der mit # gekennzeichneten Stellen stattfindet und somit A das andere Nachbaratom des Carben-Kohlenstoffatoms darstellt, das dann mit einem Rest R substituiert ist, der ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
jedes weitere R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
T ausgewählt ist aus der Gruppe bestehend aus CR₂, NR und SR, wobei jedes R unabhängig voneinander ausgewählt ist aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroaryl- Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
z für die ganzen Zahlen 1, 2, 3 oder 4 steht.

4. Metall(I)komplex nach Anspruch 1 bis 3, wobei E∩D unabhängig voneinander ausgewählt ist aus der Gruppe bestehend aus 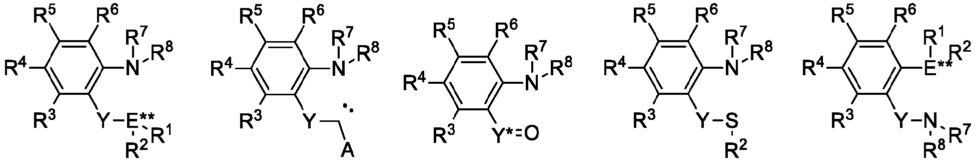 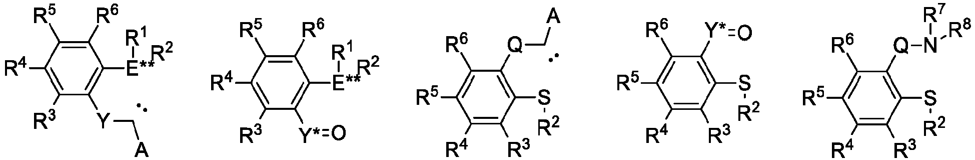 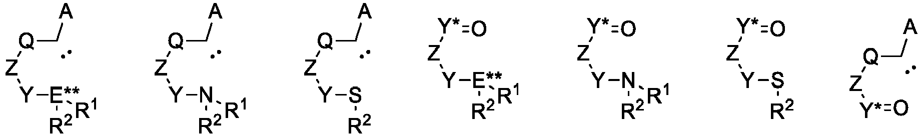 mit
E** = ausgewählt aus der Gruppe bestehend aus P, As und Sb;
: = ein Carben-Kohlenstoffatom;
A = Substituent ausgewählt aus der Gruppe bestehend aus NRR', OR, SR und PRR' sowie Alkyl-(unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
Q, Y und Z = unabhängig voneinander Substituenten ausgewählt aus der Gruppe bestehend aus NR, O, S und PR sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei A und Q und G und Y optional jeweils miteinander verbunden sind, sodass sich ein Imidazolidin- oder ein Imidazolderivat ausbildet und/oder mit der Einheit Z und/oder den Resten R³-R⁸ zu annelierten Ringsystemen führt;
R und R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
R¹-R⁸ können jeweils unabhängig voneinander ausgewählt aus der Gruppe bestehend aus Wasserstoff, Halogen sein und Substituenten, die direkt oder über Sauerstoff- (-OR), Stickstoff- (-NR₂) oder Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind; wobei R³-R⁸ optional zu annelierten Ringsystemen führen.

5. Verfahren zur Herstellung eines Metall(I)komplexes nach Anspruch 1 bis 4,
aufweisend den Schritt:
Durchführen einer Reaktion von E∩D mit M(I)X,
wobei
M = unabhängig voneinander ausgewählt aus der Gruppe bestehend aus Cu und Ag,
X = unabhängig voneinander ausgewählt aus der Gruppe bestehend aus Cl, Br, I, CN, OCN, SCN, Alkinyl und N₃;
E∩D = ein zweizähniger Ligand mit
E = RR'E* (wenn E* = N, P, As, Sb) oder RE* (wenn E* = C*, O, S) mit E* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
D = RR'D* (wenn D* = N, P, As, Sb) oder RD (wenn D* = C*, O, S) mit D* unabhängig voneinander ausgewählt aus der Gruppe bestehend aus N, wobei N kein Imin-Stickstoffatom oder Teil eines N-heteroaromatischen Rings ist, P, C*, O, S, As und Sb mit C* = ein divalentes Carben-Kohlenstoffatom und R, R' = unabhängig voneinander ausgewählt aus der Gruppe bestehend aus Wasserstoff, Halogen und Substituenten, die direkt oder über Sauerstoff- (-OR), Stickstoff- (-NR₂), Silizium- (-SiR₃) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen oder substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anneliert sind;
wobei D und E verschieden voneinander sind.

6. Verfahren nach Anspruch 5, weiterhin aufweisend den Schritt der Substitution mindestens eines Liganden E∩D mit mindestens einem Substituenten zur Erhöhung der Löslichkeit, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

7. Verfahren nach Anspruch 5 oder 6, weiterhin aufweisend den Schritt der Substitution mindestens eines Liganden E∩D mit mindestens einer funktionellen Gruppe zur Verbesserung des Ladungsträgertransports, die ausgewählt ist aus Elektronenleiter und Lochleiter.

8. Verwendung eines Metall(I)komplexes nach Anspruch 1 bis 4 als Emitter oder Absorber in einem optoelektronischen Bauelement.

9. Verwendung nach Anspruch 8, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

10. Verwendung nach Anspruch 8 oder 9, **dadurch gekennzeichnet, dass** der Anteil des Metall(I)komplexes am Emitter oder Absorber 1 % bis 99 % oder 100 % beträgt oder dass der Anteil des Metall(I)komplexes als Emitter in optischen Licht emittierenden Bauelementen, insbesondere in OLEDs, zwischen 5 % und 80 % beträgt.

11. Verwendung nach Anspruch 8 bis 10, **dadurch gekennzeichnet, dass** der Anteil des Metall(I)komplexes als Emitter in optischen Licht emittierenden Bauelementen, insbesondere in OLEDs, zwischen 5 % und 80 % beträgt.

12. Optoelektronisches Bauelement, aufweisend einen Metall(I)komplex nach Anspruch 1 bis 4.

13. Optoelektronisches Bauelement nach Anspruch 12, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Lichtemittierender elektrochemischer Zelle, organischem Feldeffekttransistor und organischem Laser.

14. Verfahren zur Herstellung eines optoelektronischen Bauelements, wobei ein Metall(I)komplex nach Anspruch 1 bis 4 verwendet wird.

15. Verfahren nach Anspruch 14, **gekennzeichnet durch** das Aufbringen eines Metall(I)komplexes nach Anspruch 1 bis 4 auf einen Träger, insbesondere wobei das Aufbringen nass-chemisch, mittels kolloidaler Suspension oder mittels Sublimation erfolgt.

16. Verwendung eines Metall(I)komplexes nach Anspruch 1 bis 4, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Claims

1. Metal(I) complex, comprising a structure of formula A 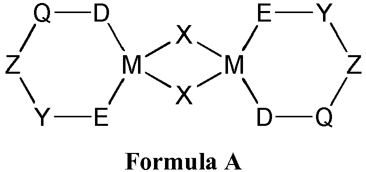 with
M = independently from each other selected from the group consisting of Cu and Ag;
X = independently form each other selected from the group consisting of Cl, Br, I, CN, OCN, SCN, alkynyl and N₃;
EnD = independently from each other a bidentate ligand with
E = RR'E* (if E* = N, P, As, Sb) or RE* (if E* = C*, O, S) with E* independently from each other selected from the group consisting ofN (wherein N is no imine nitrogen atom or part of a N-heteroaromatic ring), P, C*, O, S, As and Sb with C* = a divalent carbene carbon atom and R, R' = independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
D = RR'D* (if D* = N, P, As, Sb) or RD* (if D* = C*, O, S) with D* independently from each other selected from the group consisting of N (wherein N is no imine nitrogen atom or part of a N-heteroaromatic ring), P, C*, O, S, As and Sb with C* = a divalent carbene carbon atom and R, R' = independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
wherein D and E differ from each other;
"∩" = a three-part unit consisting of Q, Y and Z, which are bound to each other and independently from each other are selected from the group consisting of NR, O, S and PR as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups, such as, for example, amines, carboxylates and their esters, and CF₃ groups, which are optionally further substituted and/or annulated;
wherein EnD optionally comprises at least one substituent for improving charge carrier transport and/or for increasing the solubility of the metal(I) complex in an organic solvent.

2. Metal(I) complex according to claim 1, comprising a structure of formula I to IX 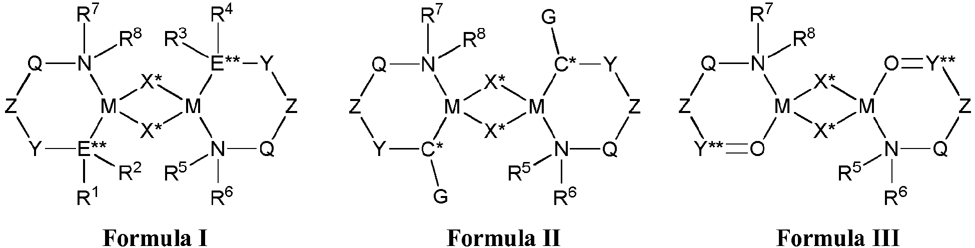 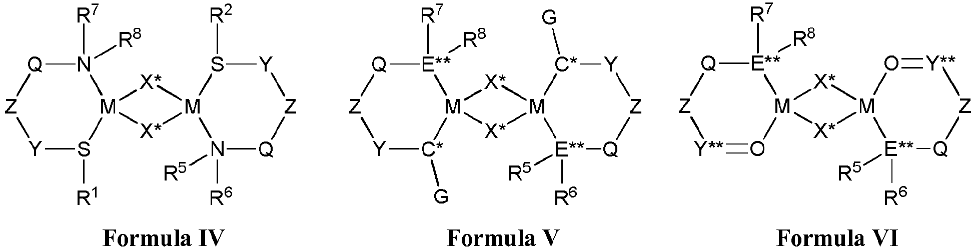 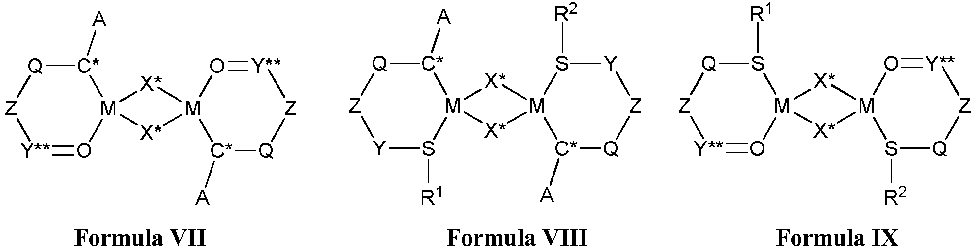 with
X* = independently from each other selected from the group consisting of Cl, Br, I, CN, OCN, SCN, alkynyl and N₃;
M = independently from each other selected from the group consisting of Cu and Ag;
E** = independently from each other selected from the group consisting of P, As and Sb;
C* = a divalent carbene carbon atom;
A and G = independently from each other substituents selected from the group consisting of NRR', OR, SR and PRR' as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups, such as, for example, amines, carboxylates and their esters, and CF₃ groups, which are optionally further substituted and/or annulated;
Q, Y and Z = independently from each other substituents selected from the group consisting of NR, O, S and PR as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups, such as, for example, amines, carboxylates and their esters, and CF₃ groups, which are optionally further substituted and/or annulated;
Y** = independently from each other selected from the group consisting of CR, N, PRR'', SR, S(O)R;
R and R' = independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
R¹-R⁸ = each independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated; wherein the groups R¹-R⁸ optionally lead to annulated ring systems.

3. Metal(I) complex according to claim 1 or 2, wherein the unit QC*A is selected independently from each other from the group consisting of 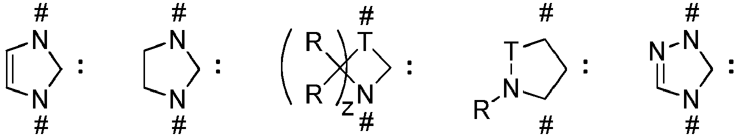 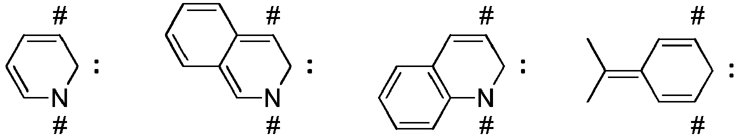 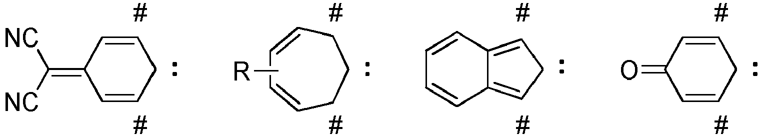 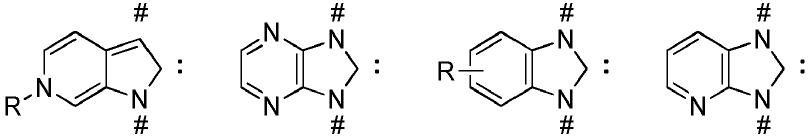 wherein
the two dots ":" represent a divalent carbene carbon atom which coordinates to the metal, and the linkage of Q with Z takes place at one of the positions marked with # and thus A represents the other neighboring atom of the carbene carbon atom, which is then substituted with a group R, which is selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
each further R is selected independently from each other from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
T is selected from the group consisting of CR₂, NR and SR, wherein each R, independently from each other, is selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
z stands for the integer 1, 2, 3 or 4.

4. Metal(I) complex according to claim 1 to 3, wherein EnD independently from each other is selected from the group consisting of 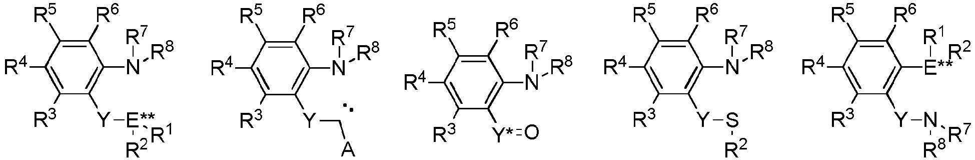 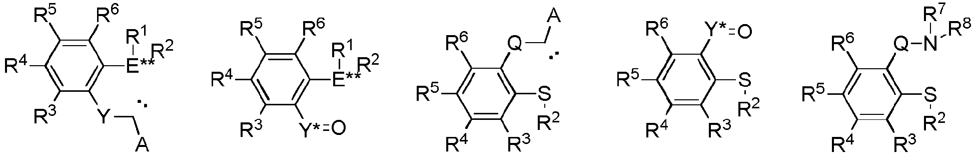 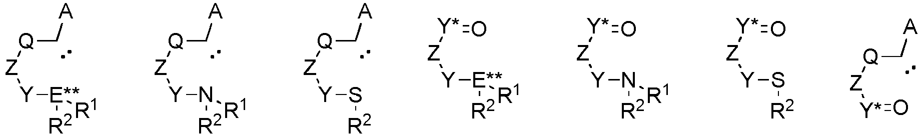 with
E** = selected from the group consisting of P, As and Sb;
: = a carbene carbon atom;
A = substituent selected from the group consisting of NRR', OR, SR and PRR' as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
Q, Y and Z = independently from each other selected from the group consisting of NR, O, S and PR as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated; wherein A and Q and G and Y optionally are each bound to each other, so that an imidazolidine or an imidazole derivative is formed and/or leads with the unit Z and/or the groups R³-R⁸ to annulated ring systems;
R and R' = independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
R¹-R⁸ are each independently from each other selected from the group consisting of hydrogen, halogen and substituents which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated; wherein R³-R⁸ optionally lead to annulated ring systems.

5. Method for the production of a metal(I) complex according to claim 1 to 4,
comprising the step:
Performing a reaction of EnD with M(I)X,
wherein
M = independently from each other is selected from the group consisting of Cu and Ag,
X = independently from each other is selected from the group consisting of Cl, Br, I, CN, OCN, SCN, alkynyl and N₃;
EnD = a bidentate ligand with
E = RR'E* (if E* = N, P, As, Sb) or RE* (if E* = C*, O, S) with E* independently from each other selected from the group consisting of N, wherein N is no imine nitrogen atom or part of an N-heteroaromatic ring, P, C*, O, S, As and Sb with C* = a divalent carbene carbon atom and R, R' = independently from each other selected from the group consisting of hydrogen, halogen and substituents, which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
D = RR'D* (if D* = N, P, As, Sb) or RD* (if D* = C*, O, S) with D* independently from each other selected from the group consisting of N, wherein N is no imine nitrogen atom or part of an N-heteroaromatic ring, P, C*, O, S, As and Sb with C* = a divalent carbene carbon atom and R, R' = independently from each other selected from the group consisting of hydrogen, halogen and substituents, which are bound directly or via oxygen (-OR), nitrogen (-NR₂), silicon (-SiR₃) or sulfur atoms (-SR) as well as alkyl (unbranched, branched or cyclic), heteroalkyl, aryl, heteroaryl, alkenyl, alkynyl groups or substituted alkyl (unbranched, branched or cyclic), heteroalkyl, aryl, heteroaryl and alkenyl groups (with substituents such as halogens or deuterium, alkyl groups (unbranched, branched or cyclic), heteroalkyl, aryl, heteroaryl groups), and further generally known donor and acceptor groups such as, for example, amines, carboxylates and their esters, and CF₃-groups, which are optionally further substituted and/or annulated;
wherein D and E are different from each other.

6. The method according to claim 5, further comprising the step of the substitution of at least one ligand EnD with at least one substituent for increasing the solubility, which can be selected from the group consisting of:
- long-chain, branched or unbranched or cyclic alkyl chains with a length of C1 to C30,
- long-chain, branched or unbranched or cyclic alkoxy chains with a length of C1 to C30,
- branched or unbranched or cyclic perfluoroalkyl chains with a length of C1 to C30, and
- short-chain polyethers.

7. The method according to claim 5 or 6, further comprising the step of substituting at least one ligand EnD with at least one functional group for improving the charge carrier transport, which is seleceted from electron conductor and hole conductor.

8. Use of a metal(I) complex according to claim 1 to 4 as emitter or absorber in an optoelectronic component.

9. Use according to claim 8, wherein the optoelectronic component is selected from the group consisting of:
- organic light-emitting diodes (OLEDs),
- light-emitting electrochemical cells,
- OLED sensors, especially in gas and vapor sensors without hermetic shielding on the outside,
- organic solar cells,
- organic field-effect transistors,
- organic lasers and
- down-conversion elements.

10. Use according to claim 8 or 9, **characterized in that** the content of the metal(I) complex in the emitter or absorber is 1 % to 99 % or 100% or that the content of the metal(I) complex as emitter in optical light-emitting components, in particular in OLEDs, is between 5 % and 80 %.

11. Use according to claim 12 to 15, **characterized in that** the content of the metal(I) complex as emitter in optical light-emitting components, in particular in OLEDs, is between 5 % and 80 %.

12. Optoelectronic component comprising a metal(I) complex according to claim 1 to 4.

13. The optoelectronic component according to claim 12, in the form of a component selected from the group consisting of organic light-emitting component, organic diode, organic solar cell, organic transistor, organic light-emitting diode, light-emitting electrochemical cell, organic field-effect transistor and organic laser.

14. A method for producing an optoelectronic component, wherein a metal(I) complex according to claim 1 to 4 is used.

15. The method according to claim 14, **characterized by** the application of a metal(I) complex according to claim 1 to 4 onto a carrier, in particular in that the application is performed by wet-chemical means, by means of colloidal suspension or by means of sublimation.

16. The use of a metal(I) complex according to claim 1 to 4, in particular in an optoelectronic component, for conversion of UV radiation or of blue light into visible light, especially to green, yellow or red light (down-conversion).

## Revendications

1. Complexe de métal (I) comprenant une structure de formule A 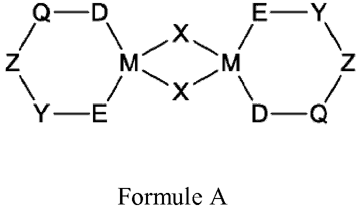 avec
M = choisis indépendamment les uns des autres dans le groupe constitué par Cu et Ag ;
X = choisis indépendamment les uns des autres dans le groupe constitué par Cl, Br, I, CN, OCN, SCN, alcynyle et N₃ ;
E∩D = indépendamment les uns des autres un ligand bidentate avec
E = RR'E* (lorsqu'E* = N, P, As, Sb) ou RE* (lorsqu'E* = C*, O, S) avec les E* choisis indépendamment les uns des autres dans le groupe constitué par N, N n'étant pas un atome d'azote d'imine ou une partie d'un cycle N-hétéroaromatique, P, C*, O, S, As et Sb avec C* = un atome de carbone de carbène bivalent et R, R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
D = RR'D* (lorsque D* = N, P, As, Sb) ou RD* (lorsque D* = C*, O, S) avec les D* choisis indépendamment les uns des autres dans le groupe constitué par N, N n'étant pas un atome d'azote d'imine ou une partie d'un cycle N-hétéroaromatique, P, C*, O, S, As et Sb avec C* = un atome de carbone de carbène bivalent et R, R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
D et E étant différents l'un de l'autre ;
« ∩ » = une unité en trois parties constituée par Q, Y et Z, qui sont reliés les uns aux autres et sont choisis indépendamment les uns des autres dans le groupe constitué par NR, O, S et PR, ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
E∩D comprenant éventuellement au moins un substituant pour l'amélioration du transport des porteurs de charges et/ou pour l'augmentation de la solubilité du complexe de métal (I) dans un solvant organique.

2. Complexe de métal (I) selon la revendication 1, comprenant une structure des formules I à IX 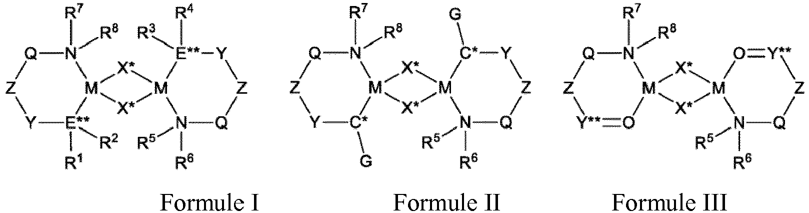 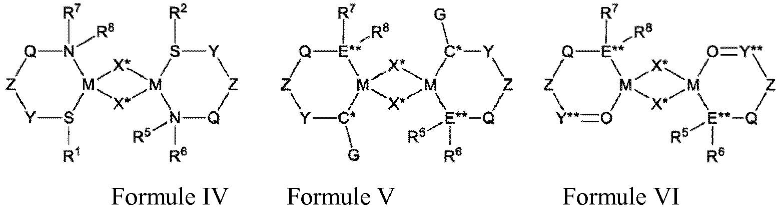 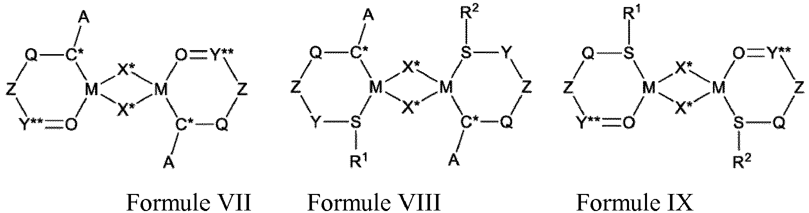 avec :
X* = choisis indépendamment les uns des autres dans le groupe constitué par Cl, Br, I, CN, OCN, SCN, alcynyle et N₃ ;
M = choisis indépendamment les uns des autres dans le groupe constitué par Cu et Ag ;
E** = choisis indépendamment les uns des autres dans le groupe constitué par P, As et Sb ;
C* = un atome de carbone de carbène bivalent ;
A et G = indépendamment les uns des autres des substituants choisis dans le groupe constitué par NRR', OR, SR et PRR', ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
Q, Y et Z = indépendamment les uns des autres des substituants choisis dans le groupe constitué par NR, O, S et PR, ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
Y** = choisis indépendamment les uns des autres dans le groupe constitué par CR, N, PRR', SR, S(O)R ;
R et R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
R¹ à R⁸ = choisis chacun indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ; les radicaux R¹ à R⁸ conduisant éventuellement à des systèmes cycliques annelés.

3. Complexe de métal (I) selon la revendication 1 ou 2, dans lequel l'unité QC*A est choisie indépendamment dans le groupe constitué par 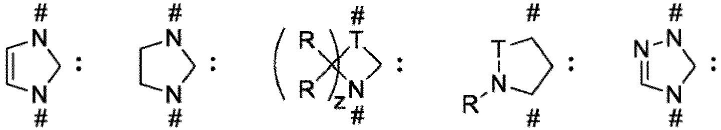 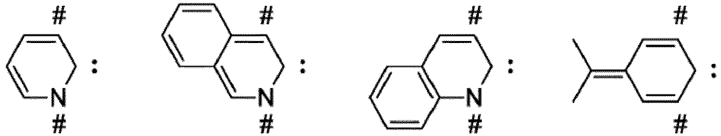 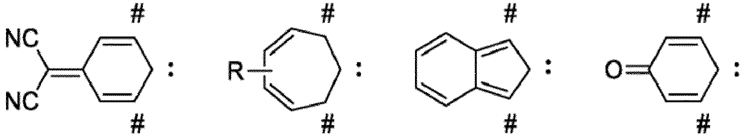 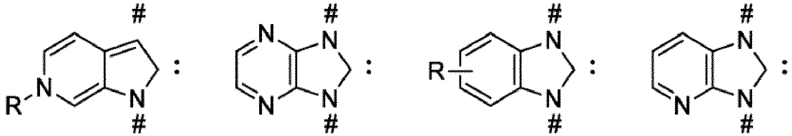 les deux points « : » représentant un atome de carbone de carbène bivalent qui est coordonné au métal, et la liaison de Q avec Z ayant lieu à un des emplacements **caractérisés par** #, et A désignant ainsi l'autre atome voisin de l'atome de carbone de carbène, qui est alors substitué avec un radical R, qui est choisi dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
les R supplémentaires étant chacun choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
T étant choisi dans le groupe constitué par CR₂, NR et SR, les R étant chacun choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
z représentant les nombres entiers 1, 2, 3 ou 4.

4. Complexe de métal (I) selon les revendications 1 à 3, dans lequel E∩D est choisi indépendamment dans le groupe constitué par 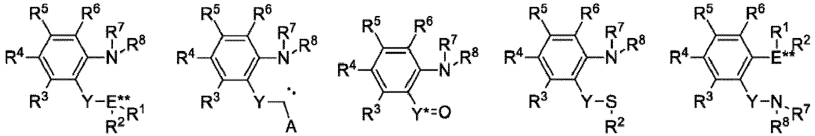 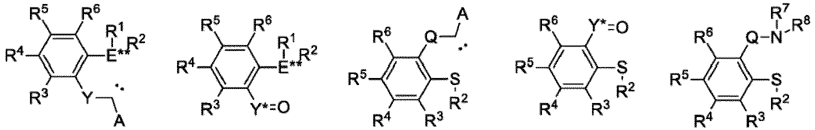 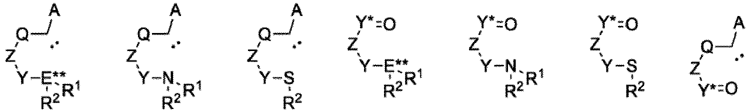 avec
E** = choisi dans le groupe constitué par P, As et Sb ;
: = un atome de carbone de carbène ;
A = substituant choisi dans le groupe constitué par NRR', OR, SR et PRR', ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
Q, Y et Z = indépendamment les uns des autres, substituants choisis dans le groupe constitué par NR, O, S et PR, ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ; A et Q et G et Y étant chacun éventuellement reliés les uns aux autres, de manière à former un dérivé d'imidazolidine ou d'imidazole, et/ou à conduire avec l'unité Z et/ou les radicaux R³ à R⁸ à des systèmes cycliques annelés ;
R et R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
R¹ à R⁸ pouvant chacun être choisis indépendamment les uns des autres dans le groupe constitué par hydrogène, halogène et des substituants qui sont reliés directement ou par des atomes d'oxygène (-OR), d'azote (-NR₂) ou de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ; les radicaux R³ à R⁸ conduisant éventuellement à des systèmes cycliques annelés.

5. Procédé de fabrication d'un complexe de métal (I) selon les revendications 1 à 4, comprenant l'étape suivante :
la réalisation d'une réaction de E∩D avec M(I)X,
avec
M = choisis indépendamment les uns des autres dans le groupe constitué par Cu et Ag ;
X = choisis indépendamment les uns des autres dans le groupe constitué par Cl, Br, I, CN, OCN, SCN, alcynyle et N₃ ;
E∩D = un ligand bidentate avec
E = RR'E* (lorsqu'E* = N, P, As, Sb) ou RE* (lorsqu'E* = C*, O, S) avec les E* choisis indépendamment les uns des autres dans le groupe constitué par N, N n'étant pas un atome d'azote d'imine ou une partie d'un cycle N-hétéroaromatique, P, C*, O, S, As et Sb avec C* = un atome de carbone de carbène bivalent et R, R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
D = RR'D* (lorsque D* = N, P, As, Sb) ou RD* (lorsque D* = C*, O, S) avec les D* choisis indépendamment les uns des autres dans le groupe constitué par N, N n'étant pas un atome d'azote d'imine ou une partie d'un cycle N-hétéroaromatique, P, C*, O, S, As et Sb avec C* = un atome de carbone de carbène bivalent et R, R' = choisis indépendamment les uns des autres dans le groupe constitué par hydrogène, halogène et des substituants qui sont reliés directement ou par des atomes d'oxygène (-OR), d'azote (-NR₂), de silicium (-SiR₃) ou de soufre (-SR), ainsi que les groupes alkyle (non ramifiés, ramifiés ou cycliques), hétéroalkyle, aryle, hétéroaryle, alcényle, alcynyle, ou les groupes alkyle (non ramifiés, ramifiés ou cycliques), hétéroalkyle, aryle, hétéroaryle et alcényle substitués (avec des substituants tels que des halogènes ou le deutérium, des groupes alkyle (non ramifiés, ramifiés ou cycliques), des groupes hétéroalkyle, aryle, hétéroaryle) et d'autres groupes donneurs et accepteurs connus de manière générale, tels que par exemple les amines, les carboxylates et leurs esters, et les groupes CF₃, qui sont éventuellement en outre substitués et/ou annelés ;
D et E étant différents l'un de l'autre.

6. Procédé selon la revendication 5, comprenant en outre l'étape de substitution d'au moins un ligand E∩D avec au moins un substituant pour l'augmentation de la solubilité, qui peut être choisi dans le groupe constitué par :
- les chaînes alkyle à chaîne longue, ramifiées ou non ramifiées ou cycliques d'une longueur de C1 à C30,
- les chaînes alcoxy à chaîne longue, ramifiées ou non ramifiées ou cycliques d'une longueur de C1 à C30,
- les chaînes perfluoroalkyle ramifiées ou non ramifiées ou cycliques d'une longueur de C1 à C30, et
- les polyéthers à chaîne courte.

7. Procédé selon la revendication 5 ou 6, comprenant en outre l'étape de substitution d'au moins un ligand E∩D avec au moins un groupe fonctionnel pour l'amélioration du transport des porteurs de charges, qui est choisi parmi les conducteurs d'électrons et les conducteurs de trous.

8. Utilisation d'un complexe de métal (I) selon les revendications 1 à 4 en tant qu'émetteur ou absorbeur dans un composant optoélectronique.

9. Utilisation selon la revendication 8, dans laquelle le composant optoélectronique est choisi dans le groupe constitué par :
- les composants électroluminescents organiques (OLED),
- les cellules électrochimiques électroluminescentes,
- les capteurs OLED, notamment dans des capteurs à gaz et vapeur non isolés hermétiquement vers l'extérieur,
- les cellules solaires organiques,
- les transistors à effet de champ organiques,
- les lasers organiques et
- les éléments de descente en fréquence.

10. Utilisation selon la revendication 8 ou 9, **caractérisée en ce que** la proportion du complexe de métal (I) dans l'émetteur ou l'absorbeur est de 1 % à 99 % ou 100 %, ou **en ce que** la proportion du complexe de métal (I) en tant qu'émetteur dans des composants optiques électroluminescents, notamment dans des OLED, est comprise entre 5 % et 80 %.

11. Utilisation selon les revendications 8 à 10, **caractérisée en ce que** la proportion du complexe de métal (I) en tant qu'émetteur dans des composants optiques électroluminescents, notamment dans des OLED, est comprise entre 5 % et 80 %.

12. Composant optoélectronique, comprenant un complexe de métal (I) selon les revendications 1 à 4.

13. Composant optoélectronique selon la revendication 12, configuré sous la forme d'un composant choisi dans le groupe constitué par un composant électroluminescent organique, une diode organique, une cellule solaire organique, un transistor organique, une diode électroluminescente organique, une cellule électrochimique électroluminescente, un transistor à effet de champ organique et un laser organique.

14. Procédé de fabrication d'un composant optoélectronique, selon lequel un complexe de métal (I) selon les revendications 1 à 4 est utilisé.

15. Procédé selon la revendication 14, **caractérisé par** l'application d'un complexe de métal (I) selon les revendications 1 à 4 sur un support, l'application ayant notamment lieu par voie chimique humide, au moyen d'une suspension colloïdale ou par sublimation.

16. Utilisation d'un complexe de métal (I) selon les revendications 1 à 4, notamment dans un composant optoélectronique, pour la conversion d'un rayonnement UV ou d'une lumière bleue en lumière visible, notamment en lumière verte, jaune ou rouge (descente en fréquence).
